(19) Europäisches Patentamt
European Patent Office
Office européen des brevets

(11) EP 3 349 317 B1

(12) EUROPEAN PATENT SPECIFICATION

(45) Date of publication and mention of the grant of the patent:
**10.11.2021 Bulletin 2021/45**

(51) Int Cl.:
***H02H 1/00*** (2006.01) ***H02H 7/20*** (2006.01)
***H02J 3/38*** (2006.01)

(21) Application number: **18151594.1**

(22) Date of filing: **15.01.2018**

# (54) ARC DETECTION AND PREVENTION IN A POWER GENERATION SYSTEM

LICHTBOGENDETEKTION UND -VERHINDERUNG IN EINEM STROMERZEUGUNGSSYSTEM

DÉTECTION ET PRÉVENTION D'ARC DANS UN SYSTÈME DE GÉNÉRATION DE PUISSANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **17.01.2017 US 201715407881**
**21.11.2017 US 201715819903**

(43) Date of publication of application:
**18.07.2018 Bulletin 2018/29**

(73) Proprietor: **Solaredge Technologies Ltd.**
**4673335 Herzeliya (IL)**

(72) Inventors:
- **Yoscovich, Ilan**
  **4673335 Herzeliya (IL)**
- **Sella, Guy**
  **4673335 Herzeliya (IL)**
- **Gazit, Meir**
  **4673335 Herzeliya (IL)**
- **Galin, Yoav**
  **4673335 Herzeliya (IL)**
- **Braginsky, David**
  **4673335 Herzeliya (IL)**
- **Handelsman, Lior**
  **4673335 Herzeliya (IL)**
- **Adest, Meir**
  **4673335 Herzeliya (IL)**
- **Loewenstern, Yakir**
  **4673335 Herzeliya (IL)**
- **Glovinsky, Tzachi**
  **4673335 Herzeliya (IL)**
- **Berkovitch, Nadav**
  **4673335 Herzeliya (IL)**
- **Neuman, Ron**
  **4673335 Herzeliya (IL)**
- **Fishelov, Amir**
  **4673335 Herzeliya (IL)**

(74) Representative: **V.O.**
**P.O. Box 87930**
**Carnegieplein 5**
**2508 DH Den Haag (NL)**

(56) References cited:
**US-A1- 2013 335 861**
**US-A1- 2014 233 136**
**US-A1- 2014 265 638**
**US-A1- 2015 381 111**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 349 317 B1

## Description

CROSS REFERENCE TO RELATED APPLICATIONS

The present application is a foreign convention application of U.S. Application 15/407,881, filed on January 17, 2017, which is a continuation-in-part (CIP) application of U.S. Application Ser. No. 13/290,528, filed November 7, 2011, which claims priority to United Kingdom Application GB1018872.0, filed November 9, 2010, U.S. Application Ser. No. 15/407,881 is also a continuation-in-part (CIP) application of U.S. Application Ser. No. 15/250,068, filed August 29, 2016, which claims priority to U.S. provisional patent Application Ser. No. 62/318,303, filed Apr. 5, 2016 and to U.S. provisional patent Application Ser. No. 62/341,147, filed May 25, 2016, U.S. Application Ser. No. 15/407,881 also claims priority to U.S. provisional patent Application Ser. No. 62/395,461, filed September 16, 2016.

FIELD

The present disclosure is related to distributed power generation systems and specifically to arc detection and prevention in photovoltaic power generation systems.

BACKGROUND

A distributed photovoltaic power generation system may be variously configured, for example, to incorporate one or more photovoltaic panels mounted in a manner to receive sunlight such as on a roof of a building. An inverter may be connected to the photovoltaic panels. The inverter typically converts the direct current (DC) power from the photovoltaic panels to alternating current (AC) power.

Arcing may occur in switches, circuit breakers, relay contacts, fuses and poor cable terminations. When a circuit is switched off or a bad connection occurs in a connector, an arc discharge may form across the contacts of the connector. An arc discharge is an electrical breakdown of a gas, which produces an ongoing plasma discharge, resulting from a current flowing through a medium such as air, which is normally non-conducting. At the beginning of a disconnection, the separation distance between the two contacts is very small. As a result, the voltage across the air gap between the contacts produces a very large electrical field in terms of volts per millimeter. This large electrical field causes the ignition of an electrical arc between the two sides of the disconnection. If a circuit has enough current and voltage to sustain an arc, the arc can cause damage to equipment such as melting of conductors, destruction of insulation, and fire. The zero crossing of alternating current (AC) power systems may cause an arc not to reignite. A direct current system may be more prone to arcing than AC systems because of the absence of zero crossing in DC power systems.

Electric arcing can have detrimental effects on electric power distribution systems and electronic equipment, and in particular, photovoltaic systems, which are often arranged in a manner that increases the risk of arching. For example, photovoltaic panels often operate at extreme temperatures due to their necessary exposure to the sun. Such conditions cause accelerated deterioration in insulation and other equipment that can lead to exposed wires. Such systems are also exposed to environmental conditions, such as rain, snow, and high humidity. Further, typical residential and/or industrial photovoltaic applications often utilize several panels connected in series to produce high voltage. Exposed conductors with high voltage in wet/humid conditions create an environment in which the probability of arching increases.

This problem of arching raises system maintenance cost and reduces the lifespan of photovoltaic panels, because photovoltaic panels and other related equipment will need to be repaired and/or replaced more frequently. Arching in photovoltaic systems also increases the risk of fire, thereby increasing operating and/or insurance cost on facilities having photovoltaic systems. The net effect of arching in photovoltaic systems is to increase the threshold at which a photovoltaic system becomes cost competitive with nonrenewable sources of energy, such as natural gas, oil, and coal.

US2013/0335861A1 and US2015/0381111A1 disclose systems which detect an arc fault.

BRIEF SUMMARY

According to a first aspect, the present invention provides a method as defined in claim 1. According to a second aspect, the present invention provides a power device as defined in claim 7. As newly described herein, systems and methods are presented to address the problem of arcing in photovoltaic systems, thereby reducing the overall cost, and extending the useful lifespan of such systems. The embodiments described herein, therefore, make deployment of photovoltaic systems in residential and industrial application more competitive with nonrenewable energy alternatives.

Methods are provided for arc detection in a photovoltaic panel system, which may include a load connectible to the photovoltaic panel with one or more mechanisms such as a power line, e.g. a DC power line. An exemplary method

not part of the present invention may measure power delivered to the load and power produced by the photovoltaic panel. These measurements may be analyzed using a suitable technique. One example of a suitable technique includes a comparison to generate, for example, a differential power measurement result. The differential power measurement result may be further analyzed using, for example, one or more static and/or dynamic threshold values. The analysis may trigger, for example, an alarm condition when the differential power measurement results deviate from one or more threshold values, either at an instant in time or over a time period when the signal is integrated or smoothed. One or more of the measurements (e.g., the second measurement), the static and/or dynamic thresholds, and/or the power measurements may be converted to a suitable format and/or modulation scheme and transmitted to a remote location. In one exemplary method, one or more of the foregoing items (e.g., the second measurement) may be modulated and transmitted (e.g., over the DC power line) to a remote location.

According to further aspects, not part of the present invention, a device for arc detection in a system may include a photovoltaic panel and a load connectible to the photovoltaic panel using, for example, a power line *(e.g.* a DC power line). In this aspect, the device may be variously configured to include one or more electronic modules adapted for measuring power produced by one or more photovoltaic panels and/or a distributed and/or centralized controller adapted for measuring power delivered to, for example, the load. Aspects may be variously configured to include one or more mechanisms to analyze power associated with the photovoltaic panel and/or power delivered to the load, dynamically and/or statically, in an instantaneous and/or integrated manner. The analysis may be variously configured to include, for example, dynamic and/or static comparisons of an instantaneous and/or integrated signal. Suitable comparisons may or may not include one or more thresholds. The analysis may collect historical data and determine variations from this historical data. Additionally, the analysis may include predetermined threshold values based on prior test data. Based on the dynamic and/or static comparison, one or more of the mechanisms may be operable to detect arcing when the power output of one or more photovoltaic panels is greater than the power delivered to the load.

According to further aspects, not part of the present invention, a method for arc detection may be performed in a system having, for example, a photovoltaic string and a load connectible to the photovoltaic string using, for example, a DC power line. The method for arc detection measurement may be variously configured, for example, to quantify a value associated with a noise voltage of the load and/or a noise voltage of one or more of the photovoltaic panels in the photovoltaic string. The quantities associated with the various measured noise voltages may be analyzed using a suitable technique. In one technique, a dynamic and/or static comparison is made between the various noise voltages e.g., (the noise voltage of the load compared with the noise voltage of one or more (e.g. all) of the photovoltaic panels in the photovoltaic string) producing a quantitative value such as a differential noise voltage value(s). The differential noise voltage value(s) may then be analyzed either statically and/or dynamically. In one embodiment, the differential noise voltage values(s) may be compared against one or more threshold values, statically and/or dynamically, instantaneously and/or integrated over time and then compared. Where a threshold is utilized, an alarm condition may be triggered where one or more of the aforementioned values exceed a threshold. For example, upon the differential noise voltage result being more than a threshold value then an alarm condition may be set; upon the alarm condition being set, the photovoltaic string may be disconnected. The various parameters discussed above may be analyzed locally and/or transmitted to a remote location. In one embodiment, one or more of the values may be modulated and transmitted over a DC power line. Upon the power of one or more or all of the photovoltaic panels or the power of photovoltaic string(s) being greater than the power as delivered to the load, then an alarm condition is set according to a previously defined static and/or dynamic criterion.

According to further aspects, not part of the present invention, one of the methods for arc detection may include software and/or circuits for measuring power delivered to the load and/or power produced by the photovoltaic string.

The measurement of the power of the photovoltaic string may be variously configured. In one example, the measurement involves sending instructions to measure the power output of each photovoltaic panel. The power value of each photovoltaic panel may then be transmitted and received. The power value of each photovoltaic panel may be added, thereby giving the second measurement result. The second measurement result may then be subsequently modulated and transmitted over the DC power line.

The load impedance may be changed according to a predetermined value. The power of the photovoltaic string, in this example, may then be measured again, thereby producing a third measurement result of the power of the photovoltaic string. Followed by the power of the load being measured, thereby producing a measurement result of the power of the load. The various measurements may be compared, thereby producing another differential power result. The various differential power results may thereby produce a total differential power result. In this example, upon the total differential power result being more than a threshold value, an alarm condition may be set. Upon the alarm condition being set, the photovoltaic string may be disconnected in the example. The third measurement result may be modulated and transmitted over the DC power line.

In this example, the measuring of the power of the photovoltaic string may involve sending one or more instruction to measure the power of each photovoltaic panel. The power value of each photovoltaic panel may then be transmitted and received. The power value of each photovoltaic panel may be added, thereby giving the third measurement result.

The third measurement result may then be subsequently modulated and transmitted over the DC power line.

The sending of instructions to measure power in the string may be to a master module connected to one of the panels of the string. Embodiments may also include slave modules respectively connected to other panels of the string, which may be instructed to measure power. Power measurement results may then be transmitted from the slave modules to the master module. The power measurement results may then be received by the master module, added up by the master module to produce a string power result, which may be transmitted to a central and/or distributed controller in this example.

In some examples not part of the present invention, a plurality of photovoltaic power devices may be configured to measure voltages in a synchronized manner, which may provide increased accuracy of a summed voltage measurement. In some embodiments, both the voltage measurements and the transmission of associated voltage measurements may be synchronized (e.g., time-synchronized, etc.). The voltage measurements may be taken at input and/or at output terminals of photovoltaic generators (e.g., photovoltaic panels, cells, substrings, etc.), in serial or in parallel photovoltaic strings. According to some aspects, the voltage measurements may be retransmitted in response to a transmission error and/or as a redundancy feature, which may prevent transmission errors or may address other issues.

Photovoltaic power devices may feature multiple output voltage terminals. In some embodiments, photovoltaic generators and photovoltaic power devices may be coupled together and/or may be arranged to provide a plurality of lower-impedance voltage loops. Designing photovoltaic string to have lower-impedance voltage loops may, in some embodiments, provide certain advantages. These advantages may include increasing a voltage sensor’s ability to detect high-frequency voltage components, which may indicate an arcing condition. According to some aspects, a lower-impedance voltage loop may also provide a way of determining a location of an arcing condition.

BRIEF DESCRIPTION OF THE DRAWINGS

The disclosure herein makes reference to the accompanying drawings, wherein:

Fig. 1a illustrates an example of a circuit showing serial arcing.
Fig. 1b illustrates the circuit of Fig.1a showing an example of parallel or shunt arcing.
Figure 2 shows a power generation system including an arc detection feature.
Figure 3 shows a method for detecting serial and/or parallel arcing.
Figure 4 shows a method for detecting serial and/or parallel arcing.
Figure 5a shows a power generation circuit.
Figure 5b shows a method for comparing a load power to a string power.
Figure 5c shows a method for measuring power of a string.
Figure 5d shows a method for serial arc detection.
Fig. 6a shows a method of detecting an electrical arc.
Fig. 6b shows a method for measuring an output voltage.
Fig. 6c shows an example data packet.
Fig. 6d shows a method for detecting an electrical arc.
Fig. 6e shows a method for estimating voltages in a photovoltaic system.
Fig. 6f shows a method for detecting an electrical arc.
Fig. 7a shows a power generation system including an arc detection feature.
Fig. 7b shows a method for detecting an arc.
Fig. 8a shows a photovoltaic power device.
Fig. 8b shows a power generation system including an arc detection feature.
Fig. 8c shows a power generation system including an arc detection feature.
Fig. 8d shows a method for detecting an arc.
Fig. 9 illustrates a photovoltaic system configuration.
Fig. 10a shows a method for extinguishing an electrical arc.
Fig. 10b shows a method for detecting and extinguishing an electrical arc.
Fig. 11a shows a first example result of carrying out the method of Fig. 10b.
Fig. 11b shows a second example result of carrying out the method of Fig. 10b.

DETAILED DESCRIPTION

Reference will now be made in detail to embodiments, examples of which are illustrated in the accompanying drawings, wherein like reference numerals refer to the like elements throughout. The embodiments are described below to explain the present disclosure by referring to the figures.

Reference is made to Figure 1a which shows serial arcing **106** in a circuit **10a** according to background art. In

Figure 1a, a direct current (DC) power supply **102** provides power between power lines **104a** and **104b.** Power line **104b** is shown at ground potential. Load **100** connects power line **104b** to power line **104a**. Serial arcing may occur in any part of circuit **10a** in power lines **104a, 104b** or internally in load **100** or supply **102** for example. A disconnection or poor connection in power line **104a** between point C and point A is shown which causes an instance **106** of serial arcing. Typically, if series arc **106** can be detected, circuit breakers (not shown) located at supply **102** or load **100** can be tripped to prevent continuous serial arcing **106.**

Reference is made to Figure 1b, which shows parallel or shunt arcing **108** in a circuit **10b** according to background art. In circuit **10b**, a direct current (DC) power supply **102** provides power between power lines **104a** and **104b.** Load **100** connects power lines **104a** and **104b.** Parallel arcing may occur in many parts of circuit **10b**, examples may include arcing between the positive of supply **102** and the ground/ chassis of supply **102**, if power supply cable **104a/b** is a two core cable; arcing may occur between the two cores, or between the positive terminal **104a** and ground **104b** of load **100.** Parallel arcing **108** may occur as shown between power line **104b** at point **D** and high potential on power line **104a** at point **C**.

Arc noise is approximate to white noise, meaning that the power spectral density is nearly equal throughout the frequency spectrum. Additionally, the amplitude of the arc noise signal has very nearly a Gaussian probability density function. The root mean square (RMS) arc noise voltage signal ($V_n$) is given in equation Eq. 1, as follows:

$$V_N = \sqrt{4KTBR} \qquad \text{Eq. 1,}$$

where:

$K$ = Boltzmann's constant = 1.38 $\times$ $10^{-23}$ Joules per Kelvin;
$T$ = the temperature in degrees Kelvin;
$B$ = bandwidth in Hertz (Hz) over which the noise voltage ($V_N$) is measured; and
$R$ = resistance (ohms) of a resistor/ circuit/ load.

Reference is now made to Figure 2, which shows a power generation system **201** including an arc detection feature according to an embodiment. A photovoltaic panel **200** is preferable connected to an input of a module **202.** Multiple panels **200** and multiple modules **202** may be connected together to form a serial string. The serial string may be formed by connecting the outputs of modules **202** in series. Multiple serial strings may be connected in parallel across a load **250.** Load **250** may be, for example, a direct current (DC) to alternating current (AC) inverter or DC-to-DC converter. An electronic module **202** may be included to measures the voltage and/or current produced by a panel **200.** Module **202** may be capable of indicating the power output of a panel **200.** Attached to load **250** may be a controller **204.** Controller **204** may be operatively attached to modules **202** via power line communications over DC power lines connecting load **250** to the serial strings and/or by a wireless connection. Controller **204** may be configured to measure via sensor **206**, the power received by load **250.** Each panel **200** has a chassis, which may be connected to ground. An instance of serial arcing **106** may occur between two panels **200.** An instance of parallel arcing **108** may be shown between the positive terminal of a panel **200** and ground of the panel **200.**

Reference is now made to Figure 3, which shows a method **301** for detecting serial and/or parallel arcing. Central controller **204** may be configured to measure one or more parameters such as the power received by load **250** (step **300).** Module **202** may be variously configured such as to measure the power of one or more panels **200** (step **302).** Module **202** may be variously configured. In one embodiment, it transmits a datum representing the power measured of the one or more panels **200** via wireless or power line communications to controller **204.** Controller **204** calculates the difference between power generated at panel(s) **200** and the power received at load **250** (step **304**). In this example, if the difference calculated in step **304** shows that the power generated at panel(s) **200** may be greater than the power received at load **250** (step **306**) according to a predefined criteria, an alarm condition of potential arcing may be set (step **308**). Otherwise, in this example, the arc detection continues with step **300**.

Reference is now made to Figure 4, which shows an illustrative method **401** for detecting serial and/or parallel arcing not part of the present invention. In a method according to this example, central controller **204** measures (step **400**) the root mean square (RMS) noise voltage of load **250.** Module **202** may then measure (step **402)** the root mean square (RMS) noise voltage of one or more panels **200.** Module **202** may be configured to transmit a datum representing the RMS noise voltage measured of panel(s) **200** via wireless or power line communications to controller **204.**

One or more controllers may be configured to compare the noise voltage at panel(s) **200** with the noise voltage at the load **250** by, for example, calculating the difference between noise voltage measured at panel **200** and the noise voltage measured at load **250** (step **404).** In this example, if the difference calculated in step **404** shows that noise voltage measured at panel(s) **200** may be greater than the noise voltage measured at load **250** (step **406)** according to one or more predefined criteria, an alarm condition of potential arcing may be set (step **408).**

Further to this example, the comparison (step **404)** also may involve comparisons of previously stored RMS noise voltage levels of panel§ **200** and/or load **250** in a memory of controller **204** at various times, for example, the time immediately after installation of power generation system **201.** The previously stored RMS noise voltage levels of both panel§ **200** and load **250** are, in this example, in the form of a look-up-table stored in the memory of controller **204.** The look-up-table has RMS noise voltage levels of both panel(s) **200** and load **250** at various times of the day, day of the week or time of year for example, which can be compared to presently measured RMS noise voltage levels of both panel(s) **200** and load **250.**

In this example, if the comparison of the measured load **250** RMS noise voltage datum with the measured panel(s) **200** RMS noise voltage datum may be over a certain threshold (step **406**) of RMS noise voltage difference an alarm condition of potential arcing may be set (step **408**) otherwise arc detection continues with step **400.**

Reference is now made to Figure 5a which shows a power generation circuit **501a** according to an example not part of the present invention. Power generation circuits **501a** have outputs of panels **200** connected to the input of modules **202**. The outputs of panels **200** may be configured to provide a DC power input ($P_{IN}$) to modules **202.** Modules **202** may include direct current (DC-to-DC) switching power converters such as a buck circuit, a boost circuit, a buck-boost circuit, configurable buck-or-boost circuits, a cascaded buck and boost circuit with configurable bypasses to disable the buck or boost stages, or any other DC-DC converter circuit. The output voltage of modules **202** may be labeled as $V_i$.

The outputs of modules **202** and module **202a** may be connected in series to form a serial string **520.** Two strings **520** may be shown connected in parallel. In one string **520,** a situation is shown of an arc voltage ($V_A$) which may be occurring serially in string **520.** Load **250** may be a DC to AC inverter. Attached to load **250** may be a central controller **204.** Controller **204** optionally measures the voltage ($V_T$) across load **250** as well as the current of load **250** via current sensor **206.** Current sensor **206** may be attached to controller **204** and coupled to the power line connection of load **250.**

Depending on the solar radiation on panels **200,** in a first case, some modules **202** may operate to convert power on the inputs to give fixed output voltages ($V_i$) and the output power of a module **202** that may be dependent on the current flowing in string **520.** The current flowing in string **520** may be related to the level of irradiation of panels **200,** e.g., the more irradiation, the more current in string **520,** and the output power of a module **202** is more.

In a second case, modules **202** may be operating to convert powers on the input to be the same powers on the output; so for example if 200 watts is on the input of a module **202,** module **202** may endeavor to have 200 watts on the output. However, because modules **202** may be connected serially in a string **520,** the current flowing in string **520** may be the same by virtue of Kirchhoff's law. The current flowing in string **520** being the same means that the output voltage ($V_i$) of a module should vary in order to establish that the power on the output of a module **202** may be the same as the power on the input of a module **202.** Therefore, in this example, as string **520** current increases, the output voltage (V;) of modules **202** decreases or as string **520** current decreases, the output voltage (V;) of modules **202** increases to a maximum value. When the output voltage (V;) of modules **202** increases to the maximum value, the second case may be similar to the first case in that the output voltage ($V_i$) may be now effectively fixed.

Modules **202** in string **520** may have a master/slave relationship with one of modules **202a** configured as master and other modules **202** configured as slaves.

Since current may be the same throughout string **520** in this example, master module may be configured to measure current of string **520.** Modules **202** optionally measure their output voltage $V_i$ so that the total string power may be determined. Output voltages of slave modules **202,** in this example, may be measured and communicated by wireless or over power line communications, for instance to master unit **202a** so that a single telemetry from module **202a** to controller **204** may be sufficient to communicate the output power of the string. Master module **202a** in string **520** may be variously configured, such as to communicate with the other slave modules **202** for control of slave modules **202.** Master module **202a**, in this example, may be configured to receive a 'keep alive' signal from controller **204**, which may be conveyed to slave modules **202.** The optional 'keep alive' signal sent from controller **204** communicated by wireless or over power line communications, may be present or absent. The presence of the 'keep alive' signal may cause the continued operation of modules **202** and/ or via master module **202a**. The absence of the 'keep alive' signal may cause the ceasing of operation of modules **202** and/ or via master module **202a** (i.e., current ceases to flow in string **520**). Multiple 'keep alive' signals each having different frequencies corresponding to each string **520** may be used so that a specific string **520** may be stopped from producing power where there may be a case of arcing whilst other strings **520** continue to produce power.

Reference is now also made to Figure 5b which shows a method **503** for comparing a load power to a string power. In step **500**, power for one or more strings **520**may be measured. In step **502,** the load **250** power may be measured using central controller **204** and sensor **206.** The measured load power and the measured string powers may be compared in step **504.** Steps 500, 502 and 504 may be represented mathematically by Equation Eq. 2 (assuming one string 520) with reference, in this example, to Figure 5a, as follows:

$$V_T I_L = \sum P_{IN} - V_A[I_L]I_L + \sum V_i I_L \qquad \text{Eq. 2,}$$

where:

$V_A [I_L]$ = the arc voltage as a function of current $I_L$;

$V_T I_L$ = the power of load **250;**

$\Sigma P_{IN}$ = the power output of modules **202** when modules **202** may be operating such that the output voltage ($V_i$) of a module varies in order to establish that the power on the output of a module **202** may be the same as the power on the input of a module **202** ($P_{IN}$); and

$\Sigma V_i I_L$ = the power output of modules **202** with fixed voltage outputs ($V_i$) and/or power output of modules **202** (with variable output voltage $V_i$) when string **520** current decreases sufficiently such that the output voltage ($V_i$) of modules **202** increases to a maximum output voltage level value. In all cases, the maximum output voltage level value ($V_i$) and fixed voltage outputs ($V_i$) may be pre-configured to be the same in power generation circuit **501a.**

The comparison between string power of string **520** and of the power ($V_T \times I_L$) delivered to load **250** may be achieved by subtracting the sum of the string **520** power ($\Sigma P_{IN} + \Sigma V_i I_L$) from the power delivered to load **250** ($V_T \times I_L$) to produce a difference. If the difference may be less than a pre-defined threshold (step **506**), the measurement of power available to string **520** (step **500**) and load **250** (step **502**) continues. In decision block **506**, if the difference may be greater than the previously defined threshold, then an alarm condition may be set and a series arc condition may be occurring. A situation of series arcing typically causes the transmission of a 'keep alive' signal to modules **202** from controller **204** to discontinue, which causes modules **202** to shut down. Modules **202** shutting down may be a preferred way to stop series arcing in string **520.**

Reference is now made to Figure 5c which shows method step **500** (shown in Figure 5b) in greater detail to measure a power of a string **520.** Central controller **204** may send instructions (step **550**) via power line communications to master module **202a.** Master module **202a** may measure the string **520** current as well as voltage on the output of master module **202a** and/or voltage and current on the input of master module **202a** to give output power and input power of module **202a** respectively. Master module may instruct (step **552**) slave modules **202** in string **520** to measure the output voltage and string **520** current and/or the input voltage and current of modules **202** to give output power and input power of modules **202** respectively. Slave modules **202** may then be configured to transmit (step **554**) to master module **202a** the input and output powers measured in step **552.** Master module **202a** receives (step **556**) the transmitted power measurements made in step **554.** Master module **202a** then adds up the received power measurements along with the power measurement made by master module **202a** (step **558**) according to equation Eq.2. According to equation Eq.2; $\Sigma P_{IN}$ = the power output of modules **202** when modules **202** may be operating such that the output voltage ($V_i$) of a module varies in order to establish that the power on the output of a module **202** may be the same as the power on the input of a module **202** ($P_{IN}$); $\Sigma V_i I_L$ = the power output of modules **202** with fixed voltage outputs ($V_i$) and/or power output of modules **202** (with variable output voltage $V_i$) when a string **520** current decreases sufficiently such that the output voltage ($V_i$) of modules **202** increases to a maximum output voltage level value. In all cases, the maximum output voltage level value ($V_i$) and fixed voltage outputs ($V_i$) may be pre-configured to be the same in power generation circuit **501a.** The added up power measurements in step **558** may be then transmitted by master module **202a** to central controller **204** (step **560**).

Reference is now made to Figure 5d, which shows a method **505** for serial arc detection. First differential power result **508** occurs in circuit **501a**, with load current $I_L$ now labeled as current $I_1$ and with voltage $V_T$ across load **250** (as shown in Figure 5a). First differential power result **508** may be produced with reference to Figure 5a and equation Eq.3 (below) as a result of performing method **503** (shown in Figure 5b). Eq. 3 is as follows:

$$V_T I_1 = \sum P_{IN} - V_A[I_1]I_1 + \sum V_i I_1 \qquad \text{Eq. 3,}$$

where:

$V_A [I_1]$ = the arc voltage as a function of current $I_1$;
$V_T I_1$ = the power of load **250;**
$\Sigma P_{IN}$ = the power output of modules **202** when modules **202** may be operating such that the output voltage ($V_i$) of a module varies in order to establish that the power on the output of a module **202** may be the same as the power

on the input of a module **202** ($P_{IN}$); and

$\Sigma V_i I_L$ = the power output of modules **202** with fixed voltage outputs ($V_i$) and/or power output of modules **202** (with variable output voltage $V_i$) when string **520** current decreases sufficiently such that the output voltage ($V_i$) of modules **202** increases to a maximum output voltage level value. In all cases, the maximum output voltage level value ($V_i$) and fixed voltage outputs ($V_i$) may be pre-configured to be the same in power generation circuit **501a.**

The impedance of load **250** may be adjusted (step **510**) optionally under control of central controller **204.** Typically, if load **250** is an inverter, controller **204** adjusts the input impedance of load **250** by variation of a control parameter of the inverter. A change in the input impedance of load **250** causes the voltage across the input of load **250** to change by virtue of Ohm's law. The voltage ($V_T$) as shown in circuit **501a** across load **250** may be therefore made to vary an amount $\Delta V$ as a result of the input impedance of load **250** being adjusted. The voltage across load **250** may be now $V_T + \Delta V$ and the load **250** current ($I_L$) may be now $I_2$.

A second differential power result **522** may be now produced as a result of performing again method **503** (shown in Figure 5c) on the adjusted input impedance of load **250** performed in step **510.** Second differential power result **522** may be represented mathematically by equation Eq. 4, as follows:

$$(V_T + \Delta V)I_2 = \sum P_{IN} - V_A[I_2]I_2 + \sum V_i I_2 \qquad \text{Eq. 4,}$$

where:

$V_A[I_2]$ = the arc voltage as a function of current $I_2$;

$(V_T + \Delta V) I_2$ = the power delivered to load **250;**

$\Sigma P_{IN}$ = the power output of modules **202** when modules **202** may be operating such that the output voltage ($V_i$) of a module varies in order to establish that the power on the output of a module **202** may be the same as the power on the input of a module **202** ($P_{IN}$); and

$\Sigma V_i I_L$ = the power output of modules **202** with fixed voltage outputs (V;) and/or power output of modules **202** (with variable output voltage $V_i$) when string **520** current decreases sufficiently such that the output voltage ($V_i$) of modules **202** increases to a maximum output voltage level value. In all cases, the maximum output voltage level value ($V_i$) and fixed voltage outputs ($V_i$) may be pre-configured to be the same in power generation circuit **501a.**

The first differential power result **508** may be compared with the second differential power result **522** (step **524**), for example, using controller **204** to subtract the first differential power result **508** from the second differential power result **522** to produce a difference. The difference may be expressed by equation Eq. 5, which may be as a result of subtracting equation Eq.3 from equation Eq.4, as follows:

$$V_T I_1 - (V_T + \Delta V)I_2 = V_A[I_2]I_2 - V_A[I_1]I_1 + \sum V_i (I_1 - I_2) \qquad \text{Eq. 5}$$

The summed output power ($P_{IN}$) of each module **202** for circuit **501a** may be thus eliminated.

Equation Eq. 5 may be re-arranged by controller **204** by performing a modulo operator function on equation Eq.5 to obtain an arc coefficient $\alpha$ as shown in equation Eq. 6.

$$\frac{V_T I_1 - (V_T + \Delta V)I_2}{(I_1 - I_2)} = \alpha + \sum V_i \qquad \text{Eq. 6}$$

where the arc coefficient $\alpha$ is shown in Eq.7

$$\alpha = \frac{V_A[I_2]I_2 - V_A[I_1]I_1}{(I_1 - I_2)} \qquad \text{Eq. 7}$$

Controller 204, for example, may be configured to calculate coefficient $\alpha$ according to the above formula and measurements. A non-zero value of arc coefficient $\alpha$ shown in equation Eq. 7 causes an alarm condition to be set (step **528**) otherwise another first differential power result **508** may be produced (step **503**). A situation of series arcing typically

causes the 'keep alive' signal to be removed by controller **204**, causing modules **202** to shut down. Modules **202** shutting down may be a preferred way to stop series arcing in string **520.**

Reference is now made to Fig. 6a, which shows a flow process (e.g. a method) **601** of detecting an arc not part of the present invention. The process 601 illustrated in Fig. 6a and/or one or more steps thereof may be performed by one or more computing devices, such as a controller computing device, which may be similar to or the same as controller **204** of Fig. 2. For example, the computing device (e.g., the controller, etc.) may be and/or include an analog circuit, microprocessor, Digital Signal Processor (DSP), Application-Specific Integrated Circuit (ASIC) and/or a Field Programmable Gate Array (FPGA). The controller may be in communication with one or more modules similar to or the same as modules **202** and may use one or more communication methods such as Power Line Communications (PLC), wireless communications (e.g. cellular communication, WiFi™, ZigBee™, Bluetooth™ or alternative protocols) and/or acoustic communication. In some embodiments, one or more aspects or steps of process **601** may be carried out by a master-module controller, e.g. a controller which may be part of a master module (e.g., module **202a**).

For illustrative, non-limiting purposes, process 601 will be described as carried out by controller 204 which may be in communication with modules 202 (e.g. in communication with modules 202 comprising communication and/or control devices) as shown in and described with respect to Fig. 2. Process 601 may be similarly used with regard to different arrangements of power modules, controllers, and other devices. According to some embodiments, controller 204 may be included in and/or in communication with a device such as a power module (e.g. power modules 202), combiner box, photovoltaic inverter, etc. According to some devices, controller 204 may be connected and/or wirelessly coupled to power modules and/or other PV devices. According to some devices, controller 204 may be a remote server configured for remote control of a PV power system. Any of the disclosed steps of Fig. 6a (and/or associated descriptions herein) may be omitted, be performed in other than the recited other, repeated, and/or combined.

Process 601 may begin at step **602**, where a computing device (e.g., the controller 204) may instruct (e.g., via one or more communication methods disclosed herein) a plurality of string-connected modules (e.g. modules **202**) to measure one or more electrical parameters. These electrical parameters may be module-based parameters (e.g., a module output voltage $V_i$). In some embodiments, the instruction may indicate a time or a timestamp at which a module may begin measuring the output voltage and/or may indicate a time interval at which a module may begin measuring the output voltage after an event, such as after receiving the instruction from the controller 204.

The taking of measurements of an electrical parameter may be synchronized, which may be used to facilitate summing of the measured parameters. For example, the controller 204 may send instructions to synchronize voltage measurements, which may be used to determine a total string voltage by summing one or more of the individual time-synched voltage measurements.

An instruction sent at step **602** may comprise an instruction for a module (e.g., in a serial string of modules) to sample output voltage $V_i$ at the instant or right after the instruction is received by a module. According to some aspects, instructions sent at step **602** may travel at speed comparable to the speed of light, i.e., $3 \cdot 10^8 m/sec$, or at some other speed. As an illustrative numerical example, if communications between the controller 204 and the modules 202 take place at about only one-third of the speed of light (e.g. about $10^8 m/sec$), and a maximum communication-path distance between any two modules 202 of the plurality of string-connected modules 202 is 100m, the respective points in time at which each respective pair of modules 202 receives the instruction might differ by no more than about $\frac{100}{10^8} = 1\mu s$. If each of the plurality of string-coupled modules 202 immediately measures a voltage upon receiving the instructions, then the plurality of measurements may be considered to be substantially simultaneous (i.e., corresponding to points in time which are close enough for the sum of the measurements to be accurately representative of the total string voltage at a single point in time).

An instruction sent at step **602** may include information for synchronizing the transmission of measurements, such as voltage measurements taken by the modules 202. For example, the instruction may instruct one or more of the modules **202** of Fig. 5a to measure an output voltage 10 seconds after receiving the instruction, may instruct a first module (e.g. **202a**) to transmit a measured output voltage 1 second (or a corresponding number of clock cycles according to a clock that may be comprised in the module) after measuring the output voltage, may instruct a second module 202 to transmit a measured output voltage two seconds after measuring the output voltage, and so on. In this manner, each of the plurality of modules 202 may measure the module output voltage at substantially the same time, but may transmit the measurement at a different time relative to another module 202, which may decrease the likelihood of simultaneous transmissions and the likelihood of possible loss of data (e.g. dropped data packets).

An instruction sent at step **602** might not instruct the modules 202 to synchronize measurement transmissions, but may instruct one or more modules 202 to wait a random period of time before transmitting a measurement. If a wide window of time is allowed for the transmissions, the probability of overlapping transmissions may be low. As an illustrative, numerical example, each module 202 may be capable of transmitting a measurement within 100msec. If forty modules 202 transmit measurements during a 5-minute window, and each module 202 broadcasts a measurement at a random

time during the 5-minute window, then with probability of $\prod_{i=0}^{39}\left(1 - i \cdot \frac{100ms}{5 \cdot 60s}\right) = 0.77$, no two measurement transmissions may overlap and each transmission may be received. According to some aspects, the probability of no two transmissions overlapping may be estimated, determined or calculated by Eq. 8, which follows:

$$p_{no_overlap} = \prod_{i=0}^{N-1}\left(1 - i \cdot \frac{transmission_time}{window_size}\right) \qquad \text{Eq. 8,}$$

where N indicates the number of transmitting modules 202, and the transmission time and window size may be selected to obtain a desired probability of non-overlapping transmissions, with *N*transmission_time <= window_size.* According to some aspects, a preferred configuration may include *transmission_time << window_size.*

It is to be understood that the elements of measurement synchronization disclosed with regard to process **601** may be similarly applied to other methods disclosed herein. For example, one or more steps of method **500** depicted in Fig. 5c may use the measurement and/or transmission synchronization as described with regard to Fig. 6a.

Step **602** might not be implemented, and each module 202 in a string of modules 202 may independently measure an output voltage measurement without receiving an instruction from the controller 204. For example, each module 202 may measure an output voltage every several minutes (e.g. every minute, every five minutes, or every fifteen minutes, etc.).

Each module 202 may measure a direct current (DC) output voltage and/or an alternating current (AC) output voltage. For example, each module 202 may comprise a DC-to-DC converter outputting a DC output voltage (or other parameter such as current), and each module 202 may measure the output DC voltage. Each module 202 may comprise a DC-to-AC converter (e.g. an inverter, or a micro-inverter, etc.) outputting an AC output voltage, and each module 202 may measure the output AC voltage (or other parameter such as current).

At step **603**, the controller 204 may receive measurements (e.g., output voltage measurements) from one or more of the plurality of modules 202. In some embodiments, each module 202 may transmit a tag (e.g., a unique code, an ID code, etc.) along with a measurement. According to some aspects, the controller 204 may compare each unique tag to a list of tags (e.g., a list held in a non-transitory computer readable memory that may be coupled to and/or included in the controller) to determine whether a voltage measurement has been received from a particular module. According to some aspects, the list of tags may be obtained prior to step **602** (i.e., in a method step not explicitly denoted in Fig. 6a_. For example, the step may include identifying one or more modules of the plurality of modules and storing the unique tag associated with each module.

Optionally, if one or more measurements might not have been properly received by the controller 204, the controller 204 may instruct one or more modules 202 to retransmit a measurement. For example, if a measurement is not received from a first module 202 and from a second module 202, in some embodiments, the controller 204 may instruct all or some of the modules 202 to retransmit measurements, and/or in some embodiments the controller 204 may request retransmission only from the first module 202 and/or the second module 202.

One or more modules 202 may initially (e.g. in response to step **602**) transmit a module output voltage measurement twice, which may provide redundancy and protection against a loss of measurements (e.g., due to overlapping transmission times). For example, in relation to Equation 8 above, if each measurement is transmitted twice, in the event of lost measurements, a probability of both measurements transmitted by a single module 202 to be lost may be very small, increasing the probability of the controller 204 receiving at least one measurement from each module 202.

At step **604**, the controller 204 may determine whether one or more of the timestamps associated with the measurements received at step 602 indicate about the same time. For example, the controller 204 may evaluate a timestamp associated with one or more of the received voltage measurements to determine whether the measurements received at step **603** indicate about the same time a respective measurement may have been taken. For example, if two timestamps indicate a small or negligible difference in time (e.g., several milliseconds), the controller 204 may determine that the measurements may have been taken at about the same time. In another example, if two timestamps indicate a large or non-negligible difference in time (e.g., several seconds, tens of seconds or minutes, or larger), the controller 204 may determine the measurements to have been taken at different times (i.e., not at about the same time). If all of the measurements or all the measurements of interest are determined to have been taken at or about the same time, the controller 204 may proceed to step **605**, which will be discussed below in more detail. If all of the measurements or all of the measurements of interest are determined to not have been taken at or about the same time, the controller 204 may proceed to step 610 and/or return to step 602.

Before returning to step **602**, the controller 204 may execute step **610.** At step **610**, one or more alternative arc-detection steps and/or methods may be utilized. For example, at step **610**, one or more voltage measurements,

which may have been received from a plurality of modules 202 and may have been determined to have been measured at different times, may be used by the controller 204 to determine or estimate a corresponding voltage for each module at a particular time (e.g., according to process **650** of Fig. 6e described below in more detail). According to some aspects, the controller 204 may proceed to step **605** and may use the voltage values determined in step **610**. According to some aspects, at step **610**, the controller 204 may compare the received voltage measurements to previously measured voltage measurements, and may determine that an arcing condition may be present based on one or more module voltages showing a trend indicating an arcing condition (e.g. a rise or fall in a measured voltage over time).

At step **605**, the controller 204 carrying out process **601** may calculate a sum of one or more of the output voltage measurements received at step **603**, which may be denoted as Σ**Vi** for voltage, but may be denoted as another symbol for other parameters such as current, power, etc. According to some aspects, Σ**Vi** may indicate a voltage (e.g., total voltage) across a string (e.g. **520**) comprising a plurality of serially-connected modules **202** or may indicate a voltage across a portion of the string.

At step **606**, the controller 204 (or other device or entity) may compare Σ**Vi** to a reference parameter (e.g., voltage, current, power, etc.). For example, the reference may be a single reference voltage or a plurality of reference voltages. In some embodiments, the reference may be a sum of voltages Σ**Vi** obtained from a previous execution of method **601** (e.g., a value saved at step **608**, which will be discussed below in more detail). In some embodiments, the reference may be a series of voltages measured over time (e.g. ten values of Σ**Vi** obtained by previous executions of method **601**). In some embodiments, the reference may be a voltage measured at a different location in a power generation circuit (e.g. **501a**) and/or in a power generation system (e.g. **201**). In one example, the reference may be a voltage measured at the input of load **250** of Fig. **5a.**

At step **607**, the controller 204 may determine whether the comparison carried out at step **606** indicates an arcing condition. For example, in some embodiments, the controller 204 may compare Σ**Vi** to a reference voltage measured at the input of load **250**, which may be denoted as **V_250**, and may determine that an arcing condition may be present if **Vdiff =** Σ**Vi — V_250 > Vthresh,** where **Vthresh** may be selected to be a minimum difference voltage that may indicate an arcing condition. In some embodiments, **Vthresh** may be about 1 volt. In some embodiments, **Vthresh** may be smaller or larger than about 1 volt. Referring back to Fig. 2, in case of a series arc **106**, a voltage drop across series arc **106** (which may be referred to as **Varc**) may begin at a low voltage (e.g., several tens or hundreds of millivolts) and over the time, **Varc** may increase, such as to several volts (e.g., such as to 10 volts, 100 volts, or even higher). According to some aspects, **Varc** might not be measured by a module **202**, but **Varc** may be reflected by **V_250**, i.e., the voltage measured at the input of load **250.** For example, **Varc** corresponding to series arc **106** might not be included in a voltage measurement taken by modules 202, but a voltage measurement taken at the input of load 250 may include a component corresponding to **Varc**. By selecting a suitable **Vthresh**, series arc **106** may be detected before a dangerous condition arises.

**Vthresh** may be selected according to historical data. For example, **Vthresh** may be selected according to differential voltages measured in power generation systems under one or more arcing conditions. In some embodiments, Σ**Vi** may be compared to previously measured voltages and/or differential voltages. For example, executing method **601** ten times, once every three minutes, may generate ten different Σ**Vi** results and ten differential voltage results **Vdiff.** If these ten **Vdiff** results (e.g. **Vdiff1, Vdiff2, ..., Vdiff10**) indicate a trend (e.g., a rising differential voltage over a period of time) and a newly obtained **Vdiffll** result continues the trend, the controller 204 may determine that an arcing condition may be present.

If the controller 204 determines at step **607** that no arcing condition might be present, the controller 204 may return to step **602** and, after a period of time, restart method **601.** In some embodiments, the controller 204 may proceed from step **607** to step **608** and save the calculated values Σ**Vi** and **Vdiff** to memory for future use, and then proceed from step **608** back to step **602.** In some embodiments, the controller 204 may save, at step **608**, additional data such as individual measurements received from modules (e.g. modules **202**), for future reference and analysis. According to an embodiment, measurements saved at step **608** may be used at steps **653-654** of method **650**, depicted in Fig. **6e**.

If the controller **204** determines at step **607** that an arcing condition might be present, the controller **204** may proceed to step **609**, and set an alarm condition. Setting an alarm condition may result in various safety protocols taking place.

For example, the controller **204** (or other device) carrying out method **601** may be coupled to a wired and/or to a wireless network(s)/Internet/Intranet, and/or any number of end user device(s) such as a computer, a smart phone, a tablet, and/or other devices such as servers which may be located at a location, such as a network operations center and/or power generation monitoring center. These devices may be utilized to generate a warning to warn of a dangerous condition and/or to take action to degrade or turn off certain portions of power generation circuit **501a.** For example, these warnings can be audio and/or visual. According to some aspects, these warnings may be a beep, a tone, a light, a siren, an LED, or a high lumen LED. These warnings may be located or actuated at a premises, such as in a home, in a building, in a vehicle, in an aircraft, in a solar farm, on a roof, in power generation circuit 501a, etc. In one example, a warning may be centralized (such as in a server) and/or distributed to end user devices (e.g., computers, smart phones,

and/or tablets). The warnings may be shown on displays coupled, attached, and/or embedded into various components of power generation circuit **501a,** such as disconnects, switches, PV cells/arrays, inverters, micro inverters, optimizers, residential current devices, meters, breakers, main, and/or junction boxes, etc. The warnings may be variously coupled to a user's or installer's cell phone and/or other device (e.g., person device, computing device, etc.) to make a user aware of a circuit in a dangerous condition and/or to warn a user when the user may be approaching or in proximity to a circuit in a dangerous condition. The warnings may be coupled to or otherwise associated with GPS coordinates and/or generated in response to a device (e.g., smart phone, tablet, etc.) moving in a location proximate to a hazard condition. The measurements sent by modules **202** and/or the summed measurement $\Sigma$**Vi** may be analyzed locally and/or sent to another device for further analysis, storage, and review.

Step **609** may include shutting down power production of a power generation system in response to an arcing condition. According to some aspects, if at step 607, the controller 204 determines that an arcing condition may be present, the controller 204 may repeat one or more steps of process 601, which may reduce the risk of a "false alarm" and/or reduce the frequency of shutting down a power generation system due to one or more inaccurate or unreliable measurements or due to measurement noise. According to some aspects, the control 24 may repeat one or more steps of process 601 more than once. According to some aspects, the execution and/or repetition of the steps of process 601 may occur in rapid succession (e.g., one second apart, several seconds apart, etc.) or may be spaced further apart (e.g., several minutes apart, several hours apart, etc.). In some embodiments, an alarm condition may be set only if two or more executions of method **601** indicate an arcing condition. According to some aspects, the process 601 may end at any time and/or after any step.

Method **601** may be carried out by a controller 204 coupled to multiple PV strings. The controller 204 may carry out method **601** with regard to each PV string (e.g. if ten PV strings are coupled to the controller 204, the controller 204 may execute method 601 ten times every 5 minutes, with each execution of method **601** applied to a different string). In some embodiments where the controller 204 is coupled to multiple PV strings, step **609** may further comprise indicating which string coupled to the controller 204 triggered the alarm condition (i.e. which string may be subject to an arcing condition).

Reference is now made to Fig. 6b, which shows a process according to an example not part of the present invention. Process **611** may be carried out by a controller or other computing device, e.g. a device configured to control a module (e.g. a photovoltaic power device such as a DC-DC converter, a DC-AC microinverter, a disconnect switch, monitoring device and similar devices). For example, the computing device (e.g., the controller, etc.) may be and/or include an analog circuit, microprocessor, Digital Signal Processor (DSP), Application-Specific Integrated Circuit (ASIC) and/or a Field Programmable Gate Array (FPGA). The controller may control one or more modules similar to or the same as modules **202** and may use one or more communication methods such as Power Line Communications (PLC), wireless communications (e.g. cellular communication, WiFi™, ZigBee™, Bluetooth™ or alternative protocols) and/or acoustic communication

For illustrative, non-limiting purposes, process 601 will be described as carried out by a controller 804 of Fig. 8a (which may be similar to or the same as controller 204 and will be discussed below in more detail), which may be a feature of power module 802 which may be similar to or the same as modules 202 of Fig. 2. The controller 804 carrying out method **611** may be in communication with a second controller 204 carrying out method **601**, e.g. using Power Line Communications (PLC), wireless communications or acoustic communications. For example, method 611 may be carried out by a controller included in a power module, and method 601 may be carried out by a controller included in a PV inverter in electrical communication with the power module. The controller 804 may measure control one or more sensors for measuring electrical parameters associated with the module, such as input and/or output voltage, current, power, solar irradiance and/or temperature, for example, sensor/sensor interface(s) 805 of Fig. 8a which may be similar to or the same as sensor 206 and will be discussed below in more detail). If sensor/sensor interface(s) 805 include a voltage sensor, the voltage sensor may be placed in parallel to detect a voltage at an input or output of, for example module 802 of Fig. 8a.

At step **612**, the controller 804 may receive an instruction (e.g., originating from a second controller 204 carrying out step **602** of method **601**) to measure a parameter (e.g., input and/or output voltage, current, power, solar irradiance and/or temperature) of an associated module (e.g., a module **202** of Fig. 2).

At step **613**, the controller (e.g. controller 804) may instruct an associated sensor to measure an output voltage of a module (e.g., module 202), and the voltage measurement may be saved to memory (e.g. memory device 809 of Fig. 8a, which will be discussed below in more detail). In some embodiments, the controller 804 may receive an instruction (e.g., at step 612 or at another time) that may indicate a certain time for carrying out one or more aspects of step **613.** For example, the instruction received at step **612** may instruct the controller 804 to measure the output voltage at a time (e.g., at 1:00:00 pm), or may instruct the controller to measure the output voltage after a predetermined period of time (e.g., 3 seconds after receiving the instruction).

At step **614**, the controller 804 may determine a period of time before the controller 804 instructs communication device 806 transmits the voltage measurement at step **615**. In some embodiments, the instruction received at step **612**

(or at another time) may indicate a time at which step **615** should be carried out, which may reduce the probability of multiple controllers transmitting simultaneously. For example, the instruction received at step **612** may indicate that the output voltage may be transmitted at 1:00:01pm (i.e., one second after measuring). In some embodiments, the controller 804 may select a period of time (e.g., a random or pseudo random period of time, etc.) to wait before transmission. For example, the controller 804 may select a random period of time between 1 second and fifteen minutes (e.g., according to a uniform distribution) to wait before transmitting the voltage measurement.

At step **615**, the voltage measurement is transmitted to an associated controller (e.g., a controller 204 carrying out method **601**). In some embodiments, the voltage measurement may be transmitted along with additional information, for example, an identification (ID) tag associated with the controller and/or a timestamp indicating the time/timestamp (or other description) at which the voltage measurement was obtained. In some embodiments, at step **615**, the voltage measurement may be transmitted more than once, which may increase the probability that the measurement will be received at least once by a receiving second controller.

At step **616**, the controller 804 may receive an instruction to retransmit a voltage measurement, for example, the controller 804 may retransmit a voltage measurement if a communication may have been lost and/or not received by another component, such as due to a transmission error. If such an instruction is received, the controller 804 may loop back to step **615** and retransmit. If no such instruction is received, the controller 804 may return to step **612** and wait to receive additional instructions to measure output voltage. According to some aspects, the process 611 may end at any time and/or after any step.

Reference is now made to Fig. 6c, which illustrates a data packet 630 according to one or more disclosed aspects not part of the present invention. Data packet **630** may comprise one or more elements, such as a sender ID tag 632, a timestamp 633 and one or more measurements 634. The sender ID 632 tag may indicate an identification (e.g., a unique ID) of an associated controller or module sending data packet **630**. The measurements 634 may comprise one or more measurements obtained by sensors at a module (e.g. 202 or 802), for example, voltage, current, power, temperature and/or irradiance measured at or near a module (e.g., modules **202**). The timestamp 633 may indicate the time at which the measurements 634 were obtained and/or measured. If several measurements were taken at different times, several timestamps 633 may be included for respective measurements. In some embodiments (e.g., in a case where the packet may be received by a device which might not be the intended final recipient), the packet may include a target ID tag 635 corresponding to an intended or subsequent recipient. In some embodiments, the packet may include a header 631 comprising metadata regarding the packet contents and may include a cyclic redundancy check (CRC) portion 636, which may provide increased data integrity.

Data packet **630** may be sent at step **615** of method **611** and/or may be received at step **603** of Fig. 6a. The timestamp 633 of data packet **630** may be read and/or processed (e.g. by a controller 204) at step **604** to verify that data packet **630** was received at about the same time as one or more other data packets. According to some aspects, the data packet 630 may comprise measurements 634 that may be used (e.g. by a controller 204) at step **605** to calculate a sum of voltages (or other parameters) measured by a plurality of modules (e.g. 202).

Reference is now made to Fig. **6d**, which illustrates a process for arc detection according one or more disclosed aspects. According to some aspects, step 610 of process 601 may include one or more steps of process **640**. Process 640 may be used by a controller (e.g., controller 204) to detect or determine an arcing condition using one or more parameter measurements (e.g., voltage measurements), which might not have been measured and/or obtained at about the same time. For example, one measurement may have been obtained at a first time and a second measurement may have been obtained at a second time.

At step **641**, a controller (e.g. 204) carrying out method **640** may evaluate a group of timestamps 633 corresponding to a respective measurement 634 of a group of parameter measurements 634 (e.g., voltage measurements, current measurements, etc.). For example, the controller may read a plurality of timestamps 633 and determine that the timestamps 633 might not be about the same (e.g. the timestamps 633 might indicate a plurality of points in time differing by seconds, tens of seconds, minutes or hours).

At step **642**, the controller 204 may select a reference timestamp ts. In some embodiments, the reference timestamp may be one of the group of timestamps 633 (e.g., the earliest timestamp, the latest timestamp, an intermediate timestamp, or the median timestamp, etc.). In some embodiments, the reference timestamp ts might not correspond to one of the group of timestamps 633 (e.g., may be an average of two or more timestamps in the group of time stamps or may be a random time within the range of timestamps).

At step **643**, the controller 204 may determine a plurality of voltage estimates, calculations, or approximations corresponding to the measured voltages at the reference timestamp **ts.** For example, if at step **641** the controller 204 evaluates timestamps **t1, t2, t3** and **t4** corresponding to the voltages $V_1[t1]$, $V_2[t3]$, $V_3[t3]$ and $V_4[t4]$ (e.g., voltages measured at four different modules **202**), at step **643**, the controller 204 may determine the voltages $\tilde{V}_1[ts]$, $\tilde{V}_2[ts]$, $\tilde{V}_3[ts]$ and $\tilde{V}_4[ts]$ (i.e., the voltages at the four modules **202** at the timestamp **ts**). According to some aspects, the controller may determine these voltage estimates by interpolation, regression analysis, etc. Aspects of step 643 are discussed below in more detail with respect to Fig. 6e.

At step **644**, the controller (e.g. 204) carrying out method **640** may calculate a sum of the output voltage measurements estimated or determined at step **643**, which may be denoted **ΣVi. ΣVi** may indicate a total voltage across a string (e.g., **520**) or portion of a string 520 comprising a plurality of serially-connected modules **202.**

Steps **645, 646** and **647** may be similar to or the same as steps **606**, **607** and **609**, respectively, of process **601**, but may instead use a value determined in step 644. Step **648** may be similar to or the same as step **608** of method **601**, but may instead use a value determined in step 644. According to some aspects, the process 640 may end at any time and/or after any step.

Reference is now made to Fig. **6e,** which illustrates a process for estimating parameters (e.g. voltages) at a particular timestamp, according to an example not part of the present invention. Method **650** may be used to estimate or determine voltage drops at a reference timestamp, for example, as step **643** of method **640** depicted in Fig. **6d.** At step **651**, all voltages to be estimated (e.g., $\boldsymbol{V_1}[\boldsymbol{ts}]$, $\boldsymbol{V_2}[\boldsymbol{ts}]$, etc.) may be initialized by the controller 204 to an "unestimated" state or an "unapproximated" state. For example, the controller 204 may recognize one or more voltages that may be used by the controller 204 in the determination of an arc condition.

At step **652**, the controller 204 may select an unestimated voltage $\boldsymbol{V_i}$ (e.g., $\boldsymbol{V_1}$) for estimation.

Estimation may comprise, for example, a direct calculation, probabilistic calculation, lookup and/or reception (e.g. via wired or wireless communication) of an estimated or determined value.

At step **653**, the controller 204 may load previously measured or obtained (e.g., measured at step **608** of method **601** in a past execution of method **601**) measurements of $\boldsymbol{V_i}$**.** For example, the controller may load ***k*** previous measurements of $V_i$, where k is a positive integer. In systems where $\boldsymbol{V_i}$ may change slowly and/or in a substantially predictable manner, the parameter ***k*** may be small, for example, ***k*** may be 1, 2 or 3. An elapsed period of time between the timestamp of the j-th previous voltage measurement and the reference timestamp ts may be referred to, for notational convenience, as $\Delta t_j$, with j being a positive integer less than or equal to ***k***.

At step 654, the controller 204 may determine an approximated voltage $\boldsymbol{V_i}[\boldsymbol{ts}]$, with the approximation denoted $\boldsymbol{\tilde{V}_i}[\boldsymbol{ts}]$**.** According to some aspects, the controller 204 may use the previous voltage measurements loaded at step 653 as input to an appropriate estimation algorithm.

A voltage $\boldsymbol{V_i}$ may vary slowly over time, and an estimated voltage at the reference timestamp may be $\boldsymbol{\tilde{V}_i}[\boldsymbol{ts}] = \boldsymbol{V_i}[\boldsymbol{ts} - \Delta \boldsymbol{t_1}]$, i.e., ***k*** = 1 and the voltage at the reference timestamp may be determined to be the same as the last measurement. In another embodiment, an estimated voltage at the reference timestamp may be calculated by fitting previous voltage measurements to a linear curve, for example, using the formula:

$$\boldsymbol{\tilde{V}_i[ts] = V_i[ts - \Delta t_1] + \frac{V_i[ts - \Delta t_1] - V_i[\Delta t_1 - \Delta t_2]}{\Delta t_1 - \Delta t_2} \cdot (ts - \Delta t_1)}$$

i.e., where ***k*** = 2. In embodiments where $\boldsymbol{V_i}$ may change more rapidly or in a more complicated manner, ***k*** may be greater than 2, and higher-order polynomials, sophisticated functions such as exponential and/or logarithmic functions, or statistical models may be used to estimate $\boldsymbol{\tilde{V}_i}[\boldsymbol{ts}]$. A threshold (e.g., a threshold used at step of method 601 607 or step 646 to determine whether a discrepancy between a sum of voltages and a reference voltage indicates an arcing condition) may be selected according to a statistical error in estimating $\boldsymbol{\tilde{V}_i}[\boldsymbol{ts}]$. For example, if $\boldsymbol{\tilde{V}_i}[\boldsymbol{ts}]$ can be estimated with high accuracy, a small threshold may be used (i.e., even a small discrepancy between a sum of voltages and a reference voltage may trigger an alarm condition indicating arcing). According to some aspects, a greater threshold may be used. According to some aspects, the voltage $V_i$ may be marked as "determined," "estimated," or "approximated."

At step **655**, the controller 204 may determine whether one or more (or all) voltages $\boldsymbol{V_i}$ have been estimated. If all voltages (or the voltages of interest) have been estimated, the controller 204 may proceed to step **656** and provide the estimated voltages $\boldsymbol{V_i}$for further analysis (e.g. to be used by a controller and/or a computing device at step 644 of process 640). If it is determined that one or more voltages (i.e., one or more voltages of interest) might not have been estimated, the process 650 may loop back to step **652**. The process 650 may end at any time and/or after any step.

Reference is now made to Fig. 6f, which illustrates a process **660** for detecting an arcing condition according to one or more disclosed aspects not part of the present invention. A device (e.g., a controller 204 or some other device) may or might not execute one or more steps of process **660** as part of a different process (e.g., as step **610** of process **601**). According to some aspects, a controller (e.g. 204) executing process **660** may detect a potential arcing condition by detecting an uncontrolled trend in measured (e.g., currently measured, previously measured, etc.) parameter (e.g. voltage, current, power and/or temperature) measurements. For illustrative purposes, voltage measurements are used to illustrate an aspect of process 660.

At step **661**, the controller 204 may receive (e.g. load from a memory component and/or receive by communication from another device) ***k*** (1, 2, 3, etc.) measured voltage measurements (e.g., measured at an input or at an output of a module **202** or at load **250**).

At step **662,** the controller 204 may attempt to detect a trend in the voltage measurements. For example, the

controller 204 may determine whether the voltage measurements show an increase or decrease over time or stay substantially the same. According to some aspects, other trends may be detected using linear regression, nonlinear regression, etc. In one example a voltage drop across an arc (e.g., arc **106**) may consistently grow over time (e.g., due to melting of conductors, which may increase an arcing air gap and thereby increase the arcing voltage), which may result in a measured voltage (e.g., at a module **202**) increasing over time. Changes in arcing voltage, which may be observed over time. may vary according to one or more parameters, including but not limited to a current flowing through the conductor at which the arc may occur, conductor material, temperature and other operational and environmental parameters. The controller (e.g. 204) executing process **660** may be calibrated according to one or more of these parameters, which may be known or determined (e.g., experimentally estimated) according to the location of the component, device, or system performing the process 660.

A voltage drop across an arc may be estimated by Eq. 9, which follows:

$$\text{Eq. 9} \qquad V_{arc} = (V_c + d \cdot V_d) \cdot \left(1 + \sqrt{{I_0}/{I}}\right)$$

where $V_{arc}$ may be a full arc voltage, $V_c$ may be a voltage at an arcing contact point, $d$ may be an arc air gap size, $V_d$ may be a parameter relating a voltage drop across the air gap to the size of the air gap $d,I$ may be the current flowing through the arc, and $I_0$ may be a parameter (e.g., a parameter that may depend on the conductor material). $I$ may be measured by a module **202** and thereby may be known, and d may grow over time (e.g., due to conductor melting), which may provide a change in measured voltages, which may indicate an arcing condition.

As an illustrative, numerical example, a system may have $V_c$ = 15[$V$], $V_d$ = $5\left[\frac{V}{mm}\right]$, $I_0$ = 1$A$, $I$ = 15$A$. An arc air gap size may grow by 0.1mm/sec, arc voltage may grow by about IV every 3 minutes, which may cause a voltage measured at an output of a module **202** to grow by 50mV every 3 minutes (e.g., in a case where an output impedance of a module **202** comprises about 5% of the total loop impedance "seen" by an arc), or may cause a voltage measured at an input of a module 202 to grow by about 500mV every 3 minutes (e.g., in a case where the arc is at an input of a module 202, and an input impedance of a module **202** is about 50% of the total loop impedance "seen" by the arc).

It is to be understood that the illustrative values provided in the numerical example above are simply indicative of possible values corresponding to a feasible scenario in one embodiment. The values may vary in alternative systems and embodiments, and the illustrative values used above are not limiting in any way.

At step **663**, the controller 204 may determine whether the voltage measurements loaded at step **661** indicate a trend, and if the measurements indicate a trend - whether the trend is controlled. An example of a controlled trend may be a startup condition, e.g., at the start of a day where one or more modules **202** may actively increase an output voltage, to provide increasing power to load **250.** Another example of a controlled trend may be a reduced voltage at an input to a module **202** caused by a module **202** executing Maximum Power Point Tracking (MPPT). Because controlled trends may occur during normal system operation, if a controlled trend is detected (e.g., by correlating the trend with commands issued by control devices or with operational changes in modules **202** and/or load **250**), the controller 204 may proceed to step **664**, which may be similar to or the same as step **608** of method 601, and may save the measurements. If an uncontrolled trend is detected at step **663**, the trend may be indicative of an arcing condition (e.g., an uncontrolled arcing condition), and the controller 204 may proceed to step **665**, which may be similar to or the same as step **609** of method 601, and may set an alarm condition. According to some aspects, the process 660 may end at any time and/or after any step.

Reference is now made to Fig. 7a, which shows a photovoltaic (PV) generation system **701** according to an illustrative example not part of the present invention. PV generation system **701** may comprise a plurality of PV generators. In the illustrative embodiment shown in Fig. 7a, each PV generator may comprise a PV panel **700**, which may be similar to or the same as panel 200. In some embodiments, the PV generators may comprise individual PV cells, substrings of PV cells, one or more PV panels and/or PV arrays. In some embodiments, the PV generators may be replaced or complemented by one or more batteries, capacitors, supercapacitors, fuel cells, wind turbines or other power generation or storage sources.

Each PV generator (in the case of Fig. 7a, each panel **700**) may be coupled to a power module **702** (e.g., **702a**, **702b**, **702c** and so on, referred to collectively as "modules **702**"). According to some aspects, a power module 702 may be similar to or the same as module 202. Each module **702** may comprise input terminals and output terminals, which may be coupled to a panel **700**. Each module **702** may be configured to receive input power at the input terminals from a panel **700**, and may be configured to provide output power at the output terminals. The power provided by the plurality

of modules **702** may be combined between a power bus and a ground bus. In the illustrative embodiment of Fig. 7a, the output terminals of each module **702** are coupled in parallel between the power bus and the ground bus. Each module may apply Maximum Power Point Tracking (MPPT) to an associated panel **700**, which may be used to extract increased power (e.g., at or about a maximum power) from the panel.

A load **750** may be coupled between the power bus and the ground bus, and may receive power generated by panels **700.** In some embodiments, load **750** may comprise a DC/AC inverter. In some embodiments, load **750** may comprise a DC or an AC combiner box, one or more safety devices (e.g. one or more fuses, residual current devices, relays, disconnect switches). In some embodiments, load 750 may include a monitoring device, for example, one or more sensors configured to measure parameters (e.g. voltage, current, power, temperature and/or irradiance) and a communication device (e.g. wires or wireless) for transmitting and/or receiving messages, commands and/or data. Controller **704** may be coupled to load **750.** In some embodiments, controller **704** may be a controller integrated in a DC/AC inverter, and may be implemented using an analog circuit, microprocessor, Digital Signal Processor (DSP), Application-Specific Integrated Circuit (ASIC) and/or a Field Programmable Gate Array (FPGA). The controller 704 may be in communication with modules **702**, using communication methods such as Power Line Communications (PLC), wireless communications (e.g., cellular communication, WiFi™, ZigBee™, Bluetooth™ or alternative protocols) and/or acoustic communications. According to some aspects, controller 704 may be the same as or similar to controller 204.

Fig. 7a illustrates a scenario in which arc **706** may occur between an output terminal of module **702c** and the power bus. Denoting the voltage between the power bus and the ground bus as **Vpg**, modules **702** may measure an output voltage of about **Vpg**, since the output terminals each module **702** may be coupled between the ground bus and the power bus. Module **702c** may measure an output voltage different from **Vpg**, due to the voltage drop across arc **706.** In accordance with method disclosed herein, each module **702** may regularly measure the output voltage across each module 702's respective output terminals, and comparison of measured output voltages may indicate an arcing condition. In the illustrative example of Fig. 7a, each module **702** (excluding module **702c**) may measure an output voltage of about 300V, and due to the 10V voltage drop across arc **706**, module **702c** may measure a voltage drop of about 310V.

One or more modules **702** may measure voltage noise, and the voltage noise measurements obtained by each module **702** may be compared (e.g. by controller 704). A voltage noise measurement obtained by module **702c** may be indicative of arc **706.** For example, if a voltage spectrum measured by module **702c** comprises significant high-frequency components at a magnitude not found in other voltage measurements, one or more processes or steps disclosed herein may determine that the measurement may be indicative of an arcing condition at or near module **702c.**

Reference is now made to Fig. 7b, which illustrates a method **711** for detecting an arc according to one example not part of the present invention. Method **711** may be carried out by a controller similar to or the same as controller **704** of Fig. 7b. In some embodiments, method 711 may be carried out by a master controller featured by a module 702. For illustrative purposes, method 711 will be described as carried out by controller 704. Steps **712-714** may be similar to or the same as steps **602-604,** respectively, of method **601.** At step **715**, the controller (e.g. 704) carrying out method **711** may compare voltage measurements received at step **714** to one another. At step **715**, the controller 704 may determine whether a measurement received from a module is different (e.g., a voltage measurement differing by more than 50mV, 500mV or more than IV from the other measurements, or a voltage noise measurement differing by tens of millivolts from other voltage noise measurements). According to some aspects the voltage difference may be compared to some threshold value, which may be set by the controller or some other device. According to some aspects this threshold may be a substantial difference between voltage measurements. According to some aspects, this threshold may be a ratio of voltages. For example, if the voltage difference is twice as large as the lower voltage measurement (corresponding to a threshold ratio of two), or ten times as large as the lower voltage measurement (corresponding to a threshold ratio of ten), or if the voltage difference is equal to the lower voltage measurement (corresponding to a threshold ratio of one), the voltage difference may be considered to be greater than the threshold. If at step **716** a determination is made that an arcing condition is unlikely, the process may proceed to step **718** where the controller 704 may save the measurements received at step **714** to memory. The controller 704 carrying out process 711 may return to step 712, such as after a period of time (e.g., five minutes) has elapsed, for a new execution of method **711.** In some embodiments, when past measurements might not have been used for reference, the process may proceed directly from step **716** back to step **712.**

If at step **716** it is determined that an arcing condition may be present (e.g., when a voltage measurement is substantially different from other voltage measurements), the process may proceed to step **717**, which may be similar to step **609** of method **601**, and may set an alarm condition. In some embodiments, the controller may repeat method **711** and only proceed to step **717** if additional repetitions indicate an arcing condition (e.g., to reduce the risk of "false alarms").

Measurements logged at step **718** may be used for reference during future executions of method **711.** For example, a first module **702** may consistently provide an output voltage measurement which differs from the other modules' output voltage (e.g., due to a faulty sensor or to a lossy element such as a damaged wire). Steps **715** and **716** may be calibrated to account for a constant or predictable measurement difference, and step **716** may be adapted to trigger step **717** if a measurement difference continuously changes (e.g., increases) over time.

Reference is now made to Fig. 8a, which illustrates circuitry **811** such as circuitry which may be found in a photovoltaic power device **802**, according to one or more aspects. Photovoltaic power device **802** may be used as, similar to, or may be module **202** of Fig. 2 and Fig. 5a and/or module **702** of Fig. 7a. In some embodiments, circuitry **811** may include power converter **801.** Power converter **801** may comprise a direct current-direct current (DC/DC) converter such as a charge pump, buck, boost, buck/boost, buck+boost, Cuk, Flyback, and/or forward converter. In some embodiments, power converter **801** may comprise a direct current - alternating current (DC/AC) converter (also known as an inverter), such as a micro-inverter. In some embodiments, circuitry **811** may include Maximum Power Point Tracking (MPPT) circuit **803**, configured to extract increased power (e.g., at or about a maximum power) from a power source (e.g., a solar panel, solar cell, etc.) the power device is coupled to. In some embodiments, power converter **801** may include MPPT functionality. Circuitry **811** may further comprise controller **804,** which may be an analog circuit, microprocessor, Digital Signal Processor (DSP), Application-Specific Integrated Circuit (ASIC) and/or a Field Programmable Gate Array (FPGA). Controller 804 may be similar to or the same as controller 204 of Fig. 2, and may be similar to or the same as a control device used to control modules 202 of Fig. 2.

Still referring to Fig. 8a, controller **804** may control and/or communicate with other elements of circuitry **811** over common bus **810.** In some embodiments, circuitry **811** may include circuitry and/or sensors/sensor interfaces **805** configured to measure parameters directly or receive measured parameters from connected sensors and/or sensor interfaces **805** configured to measure parameters on, at, or near the power source. These parameters may include the voltage and/or current output by the power source and/or the power output by the power source, and the like. In some embodiments, the power source may be a PV module, and a sensor or sensor interface 805 may measure or may receive measurements of the irradiance received by the module and/or the temperature on, at, or near the module. In some embodiments, circuitry and/or sensors/sensor interfaces **805** may be configured to measure parameters directly or receive measured parameters from connected sensors and/or sensor interfaces **805** configured to measure parameters on or near the output of PV power device **802.** These parameters may include the voltage and/or current output by PV power device **802** and/or the power output by PV power device **802.**

Still referring to Fig. 8a, in some embodiments, circuitry **811** may include communication device **806**, configured to transmit and/or receive data and/or commands from other devices. Communication device **806** may communicate using Power Line Communication (PLC) technology, acoustic communication technology or wireless technologies such as ZigBee™, Wi-Fi™, Bluetooth™, cellular communication or other wireless methods. In some embodiments, circuitry **811** may include memory device **809,** for logging measurements taken by sensor(s)/sensor interfaces **805** to store code, operational protocols or other operating information. Memory device **809** may be flash, Electrically Erasable Programmable Read-Only Memory (EEPROM), Random Access Memory (RAM), Solid State Devices (SSD) or other types of appropriate memory devices.

Still referring to Fig. 8a, in some embodiments, circuitry **811** may include safety devices **807** (e.g., fuses, circuit breakers and Residual Current Detectors). Safety devices **807** may be passive or active. For example, safety devices **807** may comprise one or more passive fuses disposed within circuitry **811** and designed to melt when a certain current flows through it, disconnecting part of circuitry **811** to avoid damage. In some embodiments, safety devices **807** may comprise active disconnect switches, configured to receive commands from a controller (e.g., controller **804**, or an external controller) to disconnect portions of circuitry **811**, or configured to disconnect portions of circuitry **811** in response to a measurement measured by a sensor (e.g., a measurement measured by sensors/sensor interfaces **805**). In some embodiments, circuitry **811** may comprise auxiliary power unit **808**, configured to receive power from a power source coupled to circuitry **811**, and output power suitable for operating other circuitry components (e.g., controller **804**, communication device **806**, etc.). Communication, electrical coupling and/or data-sharing between the various components of circuitry **811** may be carried out over common bus **810.**

Controller **804** may be configured to carry out process **611** of Fig. 6b. According to some embodiments, sensor/sensor interfaces **805** may be configured to measure the output voltage of PV power device **802** at step **613** of process **611**. According to some embodiments, communication device **806** may be configured to carry out steps **612**, **615** and/or **616** of process **611** by transmitting or receiving messages from a coupled communication device, and relaying received instructions to controller **804**. In some embodiments, communication device **806** may be configured to carry out step **554** of process **500** of Fig. 5c. In some embodiments, controller **804** may be configured to function as a "master controller" and to carry out process **601** of Fig. 6a, processor **711** of Fig. 7b, and steps **552**, **556**, **558** and (along with communication device **806**) **560** of method **500** of Fig. 5c.

Circuitry **811** might comprise a portion of the components depicted in Fig. 8a. For example, in some embodiments, PV power device **802** may be a monitoring and/or safety device, which might not include power conversion and/or MPPT functionality (i.e., circuitry **811** might not comprise power converter 801 and/or MPPT circuit 803). In some embodiments, PV power device 802 may comprise power conversion and/or MPPT functionality, but might not comprise one or more communication features (i.e., circuitry **811** might not comprise communication device **806.** For example, controller **804** may be configured to disconnect circuitry **811** from a PV string in response to detecting an arcing condition, e.g., without receiving a communication from other power devices).

In some embodiments, PV power device 802 and/or one or more components of circuitry 811 may be integrated into a photovoltaic generator. For example, circuitry 811 may be integrated into a photovoltaic generator junction box. As another example, elements of circuitry 811 (e.g., power converter 801, controller 804 and/or safety devices 807) may be embedded into PV panels or other power devices.

Reference is now made to Fig. 8b, which illustrates a portion of a photovoltaic power generation system according to an embodiment. In the illustrative embodiment depicted in Fig. 8b, a plurality of PV power devices **802** (e.g., **802a**, **802b**,...**802n**) may be coupled to a plurality of PV generators **800** (e.g., **800a**, **800b**,...**800n**) to form a photovoltaic string **820**. According to some aspects, one terminal of the resultant photovoltaic string **820** may be coupled to a power (e.g., direct current) bus, and the other terminal of the string **820** may be coupled to a ground bus. In some embodiments, the power and ground buses may be input to system power device **850**. In some embodiments, system power device **850** may include a DC/AC inverter and may output alternating current (AC) power to a power grid, home or other destinations. In some embodiments, system power device **850** may comprise a combiner box, DC-link, transformer and/or safety disconnect circuit. For example, system power device **850** may comprise a DC combiner box for receiving DC power from a plurality of PV strings similar to or the same as **820** and outputting the combined DC power. In some embodiments, system power device **850** may be coupled to a plurality of parallel-connected PV strings, and may include a fuse coupled to each PV string for overcurrent protection, and/or one or more disconnect switches for disconnecting one or more PV strings. In some embodiments, system power device **850** may comprise a Rapid Shutdown circuit, configured to rapidly reduce an input voltage to system power device **850** in response to a potentially unsafe condition (e.g., detecting an arc, or an islanding condition). In some embodiments, system power device **850** may be similar to or the same as load **250** of Fig. 2 and/or load **750** of Fig. 7a.

In some embodiments, photovoltaic (PV) power device **802a** may comprise a power converter **801a** using a variation of a Buck+Boost DC/DC converter. Power converter **801a** may include a circuit having two input terminals, denoted **Vin** and **common**, and two output terminals which output the same voltage **Vout**. The output voltage is in relation to the common terminal. The circuit may include an input capacitor C**in** coupled between the common terminal and the **Vin** terminal, an output capacitor coupled between the common terminal and the **Vout** terminals. The circuit may include a first central point and a second central point used for reference. The circuit may include a plurality of switches (e.g., MOSFET transistors) **Q1**, **Q2**, **Q3** and **Q4** with **Q1** connected between **Vin** and the first central point, and **Q2** connected between the common terminal and the first central point. **Q3** may be connected between the **Vout** terminal and the second central point, and **Q4** may be connected between the common terminal and the second central point. The circuit may further include inductor **L** coupled between the two central points.

The operation of the Buck+Boost DC/DC converter in PV power device **802a** may be variously configured. For example, if an output voltage lower than the input voltage is desired, **Q3** may be statically ON, **Q4** may be statically OFF, and with **Q1** and **Q2** being PWM-switched in a complementary manner to one another, the circuit is temporarily equivalent to a Buck converter and the input voltage is bucked. If an output voltage higher than the input voltage is desired, **Q1** may be statically ON, **Q2** may be statically OFF, and with **Q3** and **Q4** being PWM-switched in a complementary manner to one another, the input voltage is boosted. Staggering the switching of switches **Q1** and **Q2**, the circuit may convert the input voltage **Vin** to output voltage **Vout**. If current is input to the circuit by the **Vin** and **common** terminals, and the voltage drop across capacitors **Cin** and Co**ut** are about constant voltages **Vin** and **Vout** respectively, the currents input to the circuit are combined at inductor **L** to form an inductor current which is equal to the sum of the current input at the **Vin** and **common** terminals. The inductor current may be output by the pair of output terminals **Vout.** In some embodiments, more than two **Vout** terminals may be utilized to split the output current into more than two portions. In some embodiments, a single output terminal may be included, and system designers may split the output terminal externally (i.e., outside of the PV power device circuit), if desired.

In alternative embodiments, power converter **801a** may be modified or configured (e.g., by removing switches **Q3** and **Q4** and connecting the **Vout** terminals directly to the second central point) to be a regular Buck converter, or may be modified or configured (e.g., by removing switches **Q1** and **Q2** and connecting the **Vin** terminal directly to the first central point) to be a regular Boost converter.

Arranging a PV string in a manner similar to PV string **820** may provide several benefits. For example, by routing string current through two current paths, each current path carrying a portion of the total string current, cabling costs associated with arranging string **820** may be reduced (e.g., because conductors provided along with PV generators **800** may be utilized to carry part of the total string current). As a second example, by directly coupling an output of a first PV power device (e.g., **802a**) to a common terminal of a second PV power device (e.g., **802b**) such that a PV generator (e.g., **800b**) is coupled between the first and second PV power devices, the first and second PV power devices may be configured to carry out point-to-point power line communications (PTPPLC) and/or may determine (e.g., by detecting magnitudes and waveforms of a current flowing along the conduction path between the first and second PV power devices) that the first and second power devices may be adjacent to each other, potentially assisting with localization and mapping of PV power generation systems. Additional advantages disclosed herein include improved arc detection and localization capabilities using reduced-impedance voltage loops provided by the arrangement of PV string **820**.

A first **Vout** terminal of PV power device **802a** may be coupled to a negative output of PV generator **800b** at connection point 1 (denoted **CP1**). A second **Vout** terminal of PV power device **802a** may be coupled to the common terminal of PV power device **802b** at connection point 3 (denoted **CP3**). A positive output of PV generator **800b** may be coupled to the **Vin** terminal of PV power device **802b** at connection point 2 (denoted **CP2**).

At the ground bus end of PV string **820**, PV generator **800a** may be coupled to the ground bus at connection point 4 (denoted **CP4**). At the power bus end of PV string **820**, PV power device 800n may be coupled to the ground bus at connection point 5 (denoted **CP5**). For notational convenience, connection points which are not connected to the ground or power buses (e.g., connection points **CP1**, **CP2** and **CP3**) will be referred to as "middle connection points", or MCPs, and connection points which are connected to the group or power buses (e.g., connection points **CP4** and **CP5**) will be referred to as "end connection points", or ECPs.

While arcing can occur at nearly any location in a photovoltaic system, connection points may be particularly susceptible to arcing due to the risk of a faulty connection and/or ingress of dirt or humidity. By arranging a PV string similarly to PV string **820**, sensors disposed in PV power devices **802** (e.g., sensor(s)/sensor interfaces **805** of Fig. 8a) may detect the arcing condition by monitoring a voltage across two terminals of PV power device **802**, the voltage being part of a reduced voltage loop.

Reference is now made to Fig. 8c, which illustrates a portion of a photovoltaic power generation system according to an illustrative example not part of the present invention. PV string **820**, PV generators **800**, PV power devices **802** and system power device **850** may be the same as the corresponding elements of Fig. 8b. First voltage loop **881** may comprise a voltage at the input of system power device **850** (denoted **V850**), a plurality of voltages across connection points at terminals of PV generators 800 (e.g., **CP4**, **CP1**, **CP2**), a plurality of voltages across PV generators **800**, denoted **V800**, and a plurality of voltages across PV power devices **802** (i.e., a voltage between a Vout terminal and the Vin terminal of a PV power device **802**). According to Kirchhoff's Voltage Law (KVL), first voltage loop **881** may be described according to Eq. 10, which follows:

Eq. 10:

$$V_{dc} + \underbrace{\sum_{i=1}^{N} V_{800,i}}_{\alpha} + \underbrace{\sum_{i=1}^{N} \left(V_{out,802i} - V_{in,802i}\right)}_{\beta} + \underbrace{\sum_{CP \in MCP} V_{CP}}_{\gamma} + V_{CP4} + V_{CP5} = 0$$

where $\alpha$ denotes the summed voltages of PV generators **800**, $\beta$ denotes the summed **Vin-to-Vout** voltages of PV power devices **802**, and $\gamma$ denotes the summed voltages across the MCPs, i.e., across connection points between a PV generator **800** and a PV power device **802** (e.g., **CP1, CP2).** Voltage **V850** may be monitored (e.g., measured), and the input and output voltage of PV power devices (i.e., $V_{out,802}$ and $V_{in,802i}$) may be similarly monitored. Under normal (i.e., non-arcing) operating conditions, connection-point voltages may be about zero and voltages **V850**, $V_{out,802}$ and $V_{in,802i}$ may change at low-frequency or not at all (i.e., DC voltages). Under arcing conditions, an arc may inject high-frequency voltage components into a component of first voltage loop **881** (for example, if an arc is present at **CP2**, the voltage **Vcp2** may include high-frequency components). To maintain a total voltage of zero across first voltage loop **881** (i.e., as to not violate Eq. 10), the remaining voltages featured in Eq. 10 may (e.g., the voltages across one or more of PV power devices **802** and/or system power device **850**) may comprise negative high-frequency components, i.e., high-frequency voltage components having the opposite polarity compared to the high-frequency voltage components across the arc). The negative high-frequency voltage components may be detectable by sensors coupled to PV power devices **802**, PV generators **800** and/or system power device **850**. For example, a voltage sensor coupled to the inputs of system power device **850** may measure **V850**, and may be configured to raise an alarm or take corrective action in response to a **V850** voltage measurement including high-frequency components (e.g., above 1kHz) at an amplitude of over 10mV, which may indicate an arcing condition.

Voltage sensors coupled to PV power devices **802** and/or system power device **850** may be dual-purpose. For example, communication device 806 of Fig. 8a may be a Power Line Communications (PLC) device configured to carry out Frequency Shift Keying (FSK) and may comprise a voltage sensor configured to measure high-frequency voltage components. Voltage components measured at certain information bands of high frequencies may be decoded for information, and voltage components measured at noise bands of high frequencies may be determined to be indicative of an arcing condition. For example, a first frequency band between 55kHz-65kHz, a second frequency band between 75kHz-80kHz and a third frequency band between 85kHz-91kHz may all be monitored for information signals. A fourth frequency band between 100kHz-120kHz may be monitored for voltage noise indicating an arcing condition.

Certain frequency bands may be associated with or may correspond to voltage noise that might not be indicative of an arcing condition. For example, an arc detection circuit (such as disclosed herein) may be coupled to a DC/DC

converter or a DC/AC converter which may comprise one or more switches that may switch (i.e., operate, etc.) at a high frequency. The switching of the switches at a high frequency may cause voltage noise at the switching frequency and multiples thereof. For example, a converter switching one or more switches at 19kHz may generate voltage noise at 19kHz, 38kHz, 57kHz, etc. To reduce the risk of determining a false-positive arcing condition, in some embodiments, a frequency band for monitoring for an arcing condition or that may indicate an arcing condition may be selected or identified. Doing this may avoid one or more frequencies that may contain voltage noise which might not be indicative of an arcing condition (e.g., a switching frequency, etc.).

A select frequency or group of select frequencies may be used for monitoring voltage noise indicating an arcing condition. The select frequency or selected frequencies may correspond to a frequency at which an impedance of a voltage loop may be reduced. For example, the total impedance of voltage loop 881 may be lowest (due to resonating capacitive and inductive elements comprising voltage loop 881) at 10kHz. In this case, a voltage component corresponding to 10kHz may be measured for an arc indication, or a voltage component corresponding to between 5kHz and 20kHz (i.e., twice and half of the low-impedance frequency) may be measured for an arc indication. In some embodiments, a loop impedance may be adjusted (e.g., by connecting adjustable capacitive and/or inductive elements) to resonate at a selected frequency, thereby improving detection of a voltage component corresponding to the selected frequency.

Additional voltage (or other parameter) sensing circuits may be added and configured for measuring high-frequency voltage components. For example, voltage-sensing circuits (e.g., voltage-sensing inductor circuits) may be serially coupled to input or output terminals of PV power devices, system power devices and/or photovoltaic generators, and may be configured to measure high-frequency voltage components at the input or output terminals.

Still referring to Fig. 8c, a second voltage loop **880** may comprise a voltage across a PV generator (e.g., **800b**), voltages across two MCPs (e.g., **CP1** and CP2), a voltage across a connection point between two PV power devices (e.g., **802a** and **802b**), and a voltage between two terminals of a PV power device (e.g., the **Vin**-to-**common** voltage of PV power device **802b**). A plurality of voltage loops similar to voltage loop **880** may exist in a PV string **820**; a similar voltage loop may be defined with regard to each PV generator in PV string **820.** A Kirchhoffs voltage law (KVL) equation may represent voltage loop **880** according to Eq. 11, which follows:

$$V_{800} + (V_{common,802} - V_{in,802}) + V_{CP1} + V_{CP2} - V_{CP3} = 0$$

Under normal operating conditions (i.e., no arc), voltages **Vcp1**, **Vcp2** and **Vcp3** may be about zero, and Eq. 11 may reduce to Eq. 12, which follows:

$$V_{800} + (V_{common,802} - V_{in,802}) = 0 \Rightarrow$$

$$V_{800} = V_{in,802} - V_{common,802}$$

The voltage $V_{in,802} - V_{common,802}$ may be continuously monitored by a voltage sensor, which may be disposed at, near, or within a PV power device **802a.** In case of an arc at one of the connection points within voltage loop **880**, high frequency voltage components may be measured at the input of a PV power device **802** (e.g., **802b**), and in response, an alarm may be raised. In some embodiments, a voltage may be monitored across a communication device disposed at an input or output terminal of a PV power device **802**. Under normal operating conditions, a sensor may detect and/or decode voltage components at one or more frequencies that may correspond to information signal frequencies. According to some aspects, a sensor may detect and/or decode voltage components at one or more frequencies that might not corresponding to information signal frequencies, which may be indicative of an arcing condition.

An advantage which may be realized in accordance with embodiments disclosed herein may be a reduced loop impedance of second voltage loop **880**. According to some aspects, voltage sensors may be disposed at, near, or between one or more terminals of PV power devices **802** and may be configured to detect high-frequency voltage components which may be substantially larger (i.e., have a higher magnitude) than high-frequency voltage components measured within a larger loop comprising a higher loop impedance. The increased magnitude of high-frequency voltage components may facilitate early detection of arcing condition, and may enable a faster response and increased safety.

An additional advantage may include fast localization of the arc. For example, if an arc occurs at **CP1**, high-frequency voltage components may be detected at a first, high magnitude at PV power device **802b** (which may be part of voltage loop **880**), and at a second, reduced magnitude by additional PV power devices (e.g., PV power devices **802a**, **802n**, which may be part of voltage loop **881**). Comparing magnitudes of measured high-frequency voltage components may indicate that PV power device may have measured larger high-frequency voltage components, which may indicate that an arc may have occurred at or in close proximity to PV power device **802b**.

Yet another advantage of the arrangement of string **820** may be provision of a reduced-impedance loop for one or more or all connection points. In some conventional power systems, a substantial number of connection points associated with PV power devices might not be part of reduced-impedance voltage loops, potentially increasing detection time of arcing conditions. In an arrangement according to string **820**, a portion of or all connection points (e.g., with the exception of connection point **CP5**) may be part of at least one reduced-impedance voltage loop, which may reduce the time to detect an arc at any given connection point, and may provide a method for determining a location of an arcing condition.

If an arc occurs at a location other than a connection point (e.g., at the power bus, the ground bus or at conductors disposed in PV string **820**, etc.), the arc may inject high-frequency voltage components which may affect voltage measurements taken at locations within first voltage loop **881** and/or within second voltage loop **880**. Depending on the location of the arc, an increased magnitude of high-frequency voltage components may be measured. For example, if an arc occurs at a conductor disposed between **CP1** and PV generator **800b,** an increased high-frequency voltage magnitude may be measured by PV power device **802b.** As another example, if an arc occurs at **CP4,** an increased high-frequency voltage magnitude may be measured by PV power device **802a.** High frequency voltage magnitudes may include voltage magnitudes at a frequency substantially above a grid frequency, for example, 200Hz, 1kHz, 5kHz, 20kHz, 100kHz or higher. As yet another example, if an arc occurs at the ground bus, at the power bus, or at **CP4**, an increased high-frequency voltage magnitude might not be measured by any PV power device.

Reference is now made to Fig. 8d, which illustrates a process **840** for detecting an arc according to some aspects not part of the present invention. Process **840** may be carried out by one or more devices (e.g., controller 704, etc.) coupled to a PV power device (e.g., controller **804** of Fig. 8a, coupled to PV power device **802**) and/or a controller coupled to a system power device (e.g., system power device **850** of Fig. 8c).

At step **841**, a voltage may be measured at an input to the power device comprising the controller. For example, a voltage may be measured between input terminals or in series with an input or an output terminal of a PV power device.

At step **842**, the controller may determine whether the voltage measurement obtained at step **841** comprises high-frequency components which may above a threshold. The threshold may correspond to a voltage level which is above a voltage level which likely corresponds to "normal" or typical (e.g. non-arcing) system operation. The threshold may be, as illustrative numerical examples, 10mV or 100mV, or some other value. As another example, the threshold may be a voltage measured at another frequency band, or at another point in coupled circuitry. For example, a group of voltage measurements may be measured at a plurality of high frequencies, with the threshold being set as the difference in voltage between the greatest two of the voltage measurements. As another example, the threshold may be a ratio of voltage differences. For example, if a voltage level at a first high frequency is twice the magnitude of a voltage level at a second high frequency (corresponding to a threshold ratio of two), or one hundred thousand times the magnitude of a voltage level at a second high frequency (corresponding to a threshold ratio of one hundred thousand), the voltage difference may be considered to be greater than the threshold. As yet another example, a threshold may be set with respect to a low frequency voltage. For example, a DC voltage may be measured, and a threshold for high-frequency voltage components may be set at, for example, 2% of the value of the DC voltage.

If no such voltage components above a threshold are detected, the controller may return to step **841**, and after a period of time has elapsed (e.g., seconds or minutes), restart process **840** or may return to a previous step.

If, at step **842**, high-frequency voltage components above the threshold are detected, the process 840 may proceed to step **843** and determine whether the voltage components are located at frequency bands which may be used for communication. In embodiments where information might not be modulated as high-frequency voltage signals, the process 840 may proceed from step **842** directly to step **845.**

If, at step **843**, the controller determines that the high-frequency voltage components correspond to modulated information (e.g. a power-line-communication message comprising parameter measurements, instructions, or other information), the controller may proceed to step **844**. At step 844, the controller may decode the voltage measurement to determine any information contained in the voltage measurement. The process 840 may then return to step **841**.

If, at step **843**, the controller determines that the high-frequency voltage components might not correspond to modulated information (e.g. the controller determines that the high-frequency voltage components may correspond to noise)), the process 840 may proceed to step **845**, and the controller may set an alarm condition. Step **845** may be similar to or the same as step **408** of Fig. 4, step **528** of Fig. 5d, step **609** of Fig. 6a, and/or step **717** of Fig. 7b.

Step **845** may include determining a location of an arc and transmitting localization information to wired and/or wireless network(s)/Internet/Intranet, and/or any number of end user device(s) such as a computer, smart phone, tablet and/or other devices such as servers which may be located at a network operations center and/or power generation monitoring center. Determining a location of an arc may comprise comparing voltage measurements measured by a plurality of PV power devices in a string and determining that an arc is likely present in the proximity of a PV power device which measured a high-frequency voltage component which is larger than the components measured by other PV power devices.

Process **840** may be carried out by a controller device coupled to a local PV power device (e.g. modules 702

of Fig. 7a) and may include determining a location of an arc may comprise comparing measured high-frequency voltage components to a threshold. The controller may be configured to determine that the arc is adjacent to the local PV power device if the measured high-frequency voltage components are above the threshold. In some embodiments, several PV power device controllers may carry out process **840** simultaneously or sequentially, where the aggregated results of each process **840** execution may be considered by a master controller configured to set an alarm condition if more than one of the PV power device controllers determines than an arcing condition may be present.

Reference is now made to Fig. 9, which shows a photovoltaic (PV) system according to illustrative embodiments. PV system 901 may comprise a plurality of PV strings 920, each PV string 920 coupled to a string device 910, with a plurality of string devices 910 coupled in series or in parallel between a ground bus and a power bus. Each of PV strings 920 may comprise a plurality of serially-connected PV generators 900. PV generators 900 may be similar to or the same as PV panels 200 of Fig. 2, PV panels 700 of Fig. 7A and/or PV generators 800 of Fig. 8B. PV generators 900 may comprise one or more photovoltaic cells(s), module(s), substring(s), panel(s) or shingle(s). In some embodiments, PV generators 900 may be replaced by direct current (DC) batteries or alternative direct current or alternating current (AC) power sources.

A safety device 902 may be coupled at various locations in PV strings 920. For example, in some embodiments (e.g. the embodiment shown in Fig. 9), a safety device 902 may be disposed between each pair of PV generators 900. In some embodiments a safety device 902 may be disposed between groups of more than one serially-connected PV generators 900.

In some embodiments, safety devices 902 may comprise sensors/sensor interfaces for measuring electrical or thermal parameters (e.g. current, voltage, power, temperature, irradiance etc.). In some embodiments, safety devices 902 may comprise switches for disconnecting PV generators 900 in case of a potential safety condition and control/driver circuits for controlling the switches. In some embodiments, safety devices 902 may comprise arc-detection circuits configured to monitor electrical parameters (e.g. current, voltage, power) and analyze the electrical parameters to determine if an arcing condition is present. In some embodiments, safety devices 902 may comprise a wired or wireless communication device for transmitting and/or receiving measurements and/or messages.

String devices 910 may be similar to module 202 of Fig. 2, power module 702 of Fig. 7A and/or power module 802 of Fig. 8a, String devices 910 may comprise one or more of communication device 806, memory device 809, power converter 801, auxiliary power unit 808, sensor/sensor interface(s) 805, controller 804, MPPT circuit 803 and safety devices 807.

In some embodiments, a plurality of string devices 910 may be coupled in parallel between the ground bus and the power bus, as shown in Fig. 9. In some embodiments, a plurality of string devices 910 may be coupled in series between the ground bus and the power bus. In some embodiments, a plurality of string devices 910 may be coupled in a series-parallel arrangement between the ground bus and the power bus. In some embodiments, a plurality of string devices 910 may be housed by a single enclosure having multiple inputs for multiple PV strings.

Safety regulations may define a maximum allowable voltage between the ground bus and any other voltage point in PV system 901, during both regular operating conditions and during potentially unsafe conditions (e.g. a fire, grid outage, an islanding condition, arcing and the like). Similarly, safety regulations may define a maximum allowable voltage between any two voltage points in PV system 901. In some scenarios, an unsafe condition in PV system 901 may require disconnecting or short-circuiting one or more of the PV generators 900 in a PV string 920 or one or more of string devices 910.

In some embodiments, a string device 910 may respond to a potentially unsafe system condition by limiting the voltage across a PV string 920 or between the power bus and the ground bus. For example, string device 910 may comprise a converter configured to regulate a voltage of about 60V across each PV string 920 in case of a potentially unsafe condition.

In some embodiments, the power and ground buses may connect to and/or be input to system power device 950. In some embodiments, system power device 950 may include a DC/AC inverter and may output alternating current (AC) power to a load, power grid, home, or other devices or destinations. In some embodiments, system power device 950 may comprise a combiner box, a transformer, and/or a safety disconnect circuit. For example, system power device 950 may comprise a DC combiner box for receiving DC power from a plurality of PV strings 920 and outputting the combined DC power. In some embodiments, system power device 950 may include a fuse coupled to string device 910 for overcurrent protection, and/or may include one or more disconnect switches for disconnecting one or more string devices 910.

In some embodiments, system power device 950 may include or be coupled to a control device and/or a communication device for controlling or communicating with one or more safety devices 902 and/or one or more string devices 910. For example, system power device 950 may comprise a control device such as a microprocessor, Digital Signal Processor (DSP) and/or a Field Programmable Gate Array (FPGA) configured to control the operation of a string device 910. In some embodiments, system power device 950 may comprise multiple interacting control devices. System power device 950 may comprise a communication device (e.g. a Power Line Communication circuit, a wireless transceiver, etc.) configured to communicate with linked communication devices included in or coupled to safety devices 902 and/or string devices 910. In some embodiments, system power device 950 may comprise both a control device and a communication device, where the control device may be configured to determine desirable modes of operation for safety devices 902 and/or string devices 910, and the communication device may be configured to transmit operational commands and/or receive reports from communication devices included in or coupled to the safety devices 902 and/or string devices 910.

System power device 950 may be may be coupled to and/or connected to any number of other devices and/or systems, such as PV systems 100 and/or 701. For example, system power device 950 may be coupled to one or more discrete and/or interconnected devices such as disconnect(s), PV cell(s)/array(s)/panels, inverter(s), micro inverter(s), PV power device(s), safety device(s), meter(s), breaker(s), AC main(s), junction box(es), camera(s), etc. In some embodiments, system power device 950 may be coupled to and/or connected to network(s)/Intranet/Internet, computing devices, smart phone devices, tablet devices, camera, one or more servers which may include data bases and/or work stations. System power device 950 may be configured for controlling the operation of components within PV system 901 and/or for controlling the interactions with other elements coupled to PV system 901.

In some embodiments, system power device 950 may respond to a potentially unsafe system condition by limiting (e.g., decreasing to a lower voltage, decreasing to zero voltage, etc.) the voltage between the power bus and the ground bus.

In some embodiments, the power and ground buses may be further coupled to energy storage devices such as batteries, flywheels, capacitors, inductors, or other devices.

In some embodiments, safety devices 902 and/or string devices 910 may be configured to detect a proximate arcing condition and to take corrective action and/or generate a signal indicative of an arcing condition to a different device. For example, a safety device 902 may detect a possible arcing condition (e.g. using a process similar to process 840 of Fig. 8d) at a terminal of a PV generator 900, and may disconnect the PV generator 900 to prevent or reduce danger. In some embodiments, the safety device 902 may indicate and/or report the possible arcing condition to a string device 910 and/or a system power device 950 via a wired or wireless communication signal. The string device 910 and/or a system power device 950 may be configured to reduce voltage at one or more PV generators 900 or PV strings 920 or may be configured to disconnect one or more PV strings 920 to prevent or reduce danger. In some embodiments, the safety device 902 may generate (e.g., by rapid switching of a switch, etc.) a voltage and/or current noise signal indicative of an arcing condition and detectable by a string device 910.

In another example, a string device 910 may detect (e.g., using a process similar to process 840 of Fig. 8d) an arcing condition at an input terminal of the string device 910 or at an intermediate point in a PV string 920 (e.g., between two PV generators 900). The string device 910 may take corrective action by disconnecting and/or reducing voltage across the PV string 920, and/or may transmit a signal to system power device 950 indicating the arcing condition. For example, the string device 910 may send to system power device 950 a wired or a wireless communication signal indicating the arcing condition. As another example, the string device 910 may generate a noisy voltage and/or current signal between the power bus and the ground bus. The noisy voltage or current signal may be detectable by system power device 950 and may be indicative of an arcing condition. System power device 950 may be configured to respond to a signal indicative of an arcing condition, for example, by disconnecting one or more string devices 910 or PV strings 920, or by sending a command to reduce voltage across or current through a string device 910 or a PV string 920.

Reference is now made to Fig. 10a, which illustrates a flow process for extinguishing an arc according to the present invention. . Process 1000 may be carried out by one or more control devices (e.g., controller 704, etc.) coupled to a PV power device (e.g., controller 804 of Fig. 8a, coupled to PV power device 802). Additionally or alternatively, a control device may be coupled to a system power device (e.g., system power device 850 of Fig. 8c). At step 1001, the control device may cause the power device (e.g., the PV power device and/or the system power device) to draw input power from one or more PV generators and output power generated by the one or more PV generators. At step 1003, the control device may reduce the magnitude of an electrical parameter of power drawn from the PV generator(s) from a first level (e.g., a first voltage level or a first current level) to a second (reduced) level. For example, the control device may cause the power device to draw a reduced current, or may set the voltage across the inputs of the power device to a reduced voltage magnitude. If an arc is present in the system when step 1003 is executed, the reduction in voltage, current and/or power input to the power device may extinguish the arc. At step 1005, the device may wait a first predetermined period of time (e.g. several microseconds, milliseconds, tens of milliseconds or hundreds of milliseconds) and proceed to step 1007, where the input electrical parameter reduced at step 1003 is increased (for example, reset to values for drawing substantial (e.g., maximum, or near-maximum) input power).

Process 1000 may be then proceed to step 1009 to wait for a second predetermined period of time before repeating steps 1003-1007, which may repeat at regular intervals. For example, based on the values of the first predetermined time period and second predetermined time period, the device carrying out process 1000 may repeatedly reduce and increase an electrical parameter every several hundred milliseconds, every second, or every several seconds. Thus, the second predetermined time period may be significantly longer (e.g., 100—10,000 times or more) than the first

predetermined time period. In this manner, in case an arc is caused by transitory and/or temporary conditions, it may be extinguished within a safe timespan without need for manual intervention to shut down the system and/or restart the system after an arc is extinguished.

In a case where an arc is extinguished at step 1003, resumption of regular system operation at step 1007 may proceed without a repetition of the arcing condition. Some arcs may be caused by temporary and/or transitory conditions such as moisture, temperature or other conditions that might be resolved by a single arc extinguishment, without requiring a full system shutdown and manual intervention.

Reference is now made to Fig. 10b, which shows a flow process in accordance with disclosed aspects not part of the present invention.

- Process 1010 may be carried out by one or more control devices (e.g., controller 704, etc.) coupled to a PV power device (e.g., controller 804 of Fig. 8a, coupled to PV power device 802). Additionally or alternatively, a control device may be coupled to a system power device (e.g., system power device 850 of Fig. 8c). At step 1011, the control device may measure noise of an electrical parameter of power (e.g., a high-frequency component of voltage measured at the power device input or a high-frequency component of current measured flowing to the power device input). The measured electrical noise may be saved (e.g., saved to a memory device) as a first measurement. At step 1013, the control device may compare the first measurement to a first threshold. If, at step 1015, the control device determines that the first measurement is not above the first threshold, the control device may interpret the result of the comparison as an indication of no-arcing, and after a suitable time period (e.g. tens or hundreds of milliseconds), the control device may return to step 1011.

If, at step 1015, the control device determines that the first measurement is above the first threshold, the control device may interpret the result as an indication of possible arcing, and proceed to step 1017 to operate the power device to reduce power input to the power device. For example, the control device may operate the power device to reduce the voltage across and/or the current flowing to the power device input. At step 1017, the control device may wait a predetermined time period (e.g., to allow the electrical parameter to settle at the reduced level and/or for an arc to extinguish). At step 1019, the control device may again measure noise of the electrical parameter of power (e.g., a high-frequency component of voltage measured at the power device input or a high-frequency component of current measured flowing to the power device input) and save the measurement as a second measurement. At step 1021, the control device may compare the second measurement to the first measurement and calculate a difference, for example, by subtracting the second measurement from the first measurement. At step 1023, the control device may compare the difference to a second threshold. If the difference is above the second threshold, the control device may determine that an arc may have been present in the electrical system prior to the reduction of the electrical parameter and may therefore set an alarm condition at step 1025 (e.g., similar to or the same as the alarm condition of step 845 of Fig. 8d).

If the difference is not above the second threshold, the control device may determine that there was no arcing (e.g., the noise may have been due to interference from another source, rather than an electrical arc). Therefore, after a suitable time period (e.g. several milliseconds, or tens or hundreds of milliseconds), the control device may resume normal operation of the power device at step 1027 (by increasing the value of the electrical parameter reduced at step 1017) and return to step 1011.

At step 1023, instead of comparing the difference to a second threshold, the control device may directly compare the second measurement to a second threshold. Similarly, the control device carrying out process 1010 may be configured such that the control device may proceed from step 1015 to step 1017 if the first measurement is *below* the first threshold, and/or the control device carrying out process 1010 may be configured such that the control device may proceed from step 1023 to step 1025 if the second measurement or the difference is *below* the second threshold (e.g., if the difference calculated at step 1021 is calculated by subtracting the first measurement from the second measurement).

If, prior to and/or during the execution of process 1010, an arc is present in the system including the power device, the reduction of the electrical parameter (e.g. voltage, current, power) at step 1017 may extinguish the arc. If an arc is extinguished because of the reduction at step 1017, the control device may determine at step 1023 that the difference is above the second threshold. After extinguishing the arc, some safety regulations may require manual inspection of the electrical system before returning to normal operation. Accordingly, even though the arc was extinguished, the control device may set the alarm condition at step 1025. Some safety regulations may allow a system to resume normal operation automatically after an arc is extinguished. Therefore, the control device can also be configured to cause the power device to resume normal operation at step 1027 without setting an alarm condition after an arc is extinguished. Additionally, some parameters used in implementation of process 1010 (e.g., the first threshold, or parameters used to measure the noise for the first measurement) might be calibrated in a manner that may generate potential false alarms at step 1015, with steps 1019-1023 providing an added verification layer to a determination that an arc is present.

The two-stage method illustrated by process 1010 may provide an accurate and robust manner of detecting

arcs while reducing a risk of false alarms. For example, a high-magnitude noise measurement may be obtained by temporary interference or a faulty sample, and the risk of erroneously interpreting the high-magnitude noise measurement as indicative of an arc may be reduced by implementing steps 1017-1023. Additionally, process 1010 may extinguish an arc (e.g., at step 1017) before setting an alarm condition (at step 1025), which, according to some potential safety regulations, may reduce system down-time by allowing the system to return to normal operation without manual intervention.

Reference is now made to Fig. 11a, which illustrates a first example result of carrying out process 1010, according to one or more illustrative aspects of the disclosure herein. Fig. 11a shows plot 1100 showing illustrative current 1101 and noise 1102 as measured over time in a photovoltaic installation where process 1010 is implemented. Current 1101 may be the magnitude of an AC current output by a system power device (e.g. system power device 950 of Fig. 9), a DC current input to a system power device, a DC current output by a PV power device (e.g. PV power device 702 of Fig. 7a) or a DC current input to a PV power device. Noise 1102 may be a noise signal obtaining by sampling and calculating a high-frequency current or voltage component. Noise 1102 may be referred to using decibel (dB) units. The x-axis of plot 1100 is a time axis, in milliseconds.

In this example, until time t1, the system represented in plot 1100 may be operating under normal operating conditions, with current 1101 having a value of about 12[A], and noise 1102 samples being around 3-7[dB]. If, for example, the control device for carrying out process 1010 is implemented such that the first threshold is 20[dB], the control device operating the power device or system power device (and carrying out process 1010) may loop between steps 1011-1015. At time t1, an arc may suddenly develop in the system, resulting in noise 1102 increasing to around 40[dB]. The next time the device reaches step 1015 of process 1010, at time t2, the device proceeds to step 1017 and, according to this illustrative example, reduces current 1101 from about 12[A] at time t2 to about 1[A] at time t3. The reduction in current 1101 is shown to reduce noise 1102 from about 40[dB] to about OdB. At step 1019, the second measurement will be about OdB, and the difference calculated at step 1021 will be about 40[dB]. At step 1023 (sometime after time t3), the difference may be determined to be above a second threshold (which may be, for exemplary purposes, 20[dB]), and the device may determine that an arc was extinguished. Plot 1100 illustrates an example in which an arcing condition is extinguished at step 1017 of process 1010. Some safety regulations may require that in case an arcing condition is extinguished (e.g., at step 1017), an alarm condition must be raised (e.g., the control device may proceed to step 1025) and/or manual intervention (e.g., a maintenance worker physically inspecting the system to check for faulty components, and resetting a manual switch) may be required to restore the system to normal operation. Accordingly, as illustrated at Fig. 11a, the system may continue operating in a reduced power mode until a later time period (not illustrated) in which the system is inspected and restored to normal mode (e.g., using a manual switch).

Reference is now made to Fig. 11b, which illustrates a second example result of carrying out process 1010, according to one or more illustrative aspects of the disclosure herein. Fig. 11b shows plot 1103 showing illustrative current 1104 and noise 1105 as measured over time in a photovoltaic installation where process 1010 is implemented. In the example of Fig. 11b, reducing current 1104 at time t2 reduces noise 1105 from about 40[dB] to about 30[dB]. The 10[dB] reduction might indicate that noise 1105 is not due to an arc (e.g., noise 1105 may be caused by an external factor such as electromagnetic interference from nearby electronic devices). The difference calculated at step 1021 of process 1010 of Fig. 10b may be about 10[dB], which might be below the second threshold (which may be, for exemplary purposes, 20[dB]). At time t3 (or at some point afterwards), the control device carrying out process 1010 may determine (at step 1023) that an arcing condition is not present, and may resume normal operation of the power device at step 1027 (by increasing the value of the electrical parameter reduced at step 1017, as shown at time t4 in plot 1103) and return to step 1011.

The definite articles "a", "an" is used herein, such as "an arc voltage and/or arc current", "a load" have the meaning of "one or more" that is "one or more arc voltages and/or arc currents" or "one or more loads".

While the disclosure contains a limited number of examples, it will be appreciated that many variations, modifications and other applications based on the disclosure may be made. For example, elements of measurement synchronization disclosed with regard to process **601** may be similarly applied to other processes and aspects disclosed herein. For example, steps **552-554** of process **500** depicted in Fig. 5c may make similar use of measurement and/or transmission synchronization as described with regard to Fig. 6a. As another example, process **840** may be carried out by a single controller (e.g., controller **804** of Fig. **8a**) or by several controllers acting in conjunction. As yet another example, aspects disclosed herein may be combined with other disclosed aspects. For example, step **610** described with regard to method **601** may be added to method **711,** such that if step **714** of method **711** determines that all voltage measurements were not measured at about the same time, the controller executing method **711** proceeds to a step similar to step **610.**

PV generators and PV panels have been used to exemplify illustrative power sources in power generation systems disclosed herein. Apparatuses and methods disclosed herein may be implemented in power generation systems comprising batteries, capacitors, supercapacitors, fuel cells, wind turbines, hydro-generators, or other power sources in addition to or instead of PV generators and/or PV panels.

## Claims

1. A method comprising:

   drawing, by a power device (802, 850), input power from at least one photovoltaic generator (800), wherein the input power is at a first voltage level and a first current level;
   providing output power at an output of the power device (802, 850);
   reducing an electrical parameter of the input power to a level that allows an electrical arc to be extinguished, the electrical parameter being at least one of a voltage of the input power and a current of the input power;
   **characterized by** the steps of:

      responsive to a first predetermined time period elapsing, increasing the electrical parameter of the input power; and
      responsive to a second predetermined time period elapsing, again reducing the electrical parameter of the input power to the level that allows an electrical arc to be extinguished.

2. The method of claim 1, wherein the power device (802, 850) is a photovoltaic inverter.

3. The method of claim 1, wherein the power device (802, 850) is a direct current to direct current power converter.

4. The method of any of claims 1-3, wherein the electrical parameter is the current of the input power, and wherein reducing the electrical parameter comprises reducing the current of the input power to a second current level, wherein the second current level allows an electrical arc to be extinguished.

5. The method of any of claims 1-3, wherein the electrical parameter is the voltage of the input power, and wherein reducing the electrical parameter comprises reducing the voltage of the input power to a second voltage level, wherein the second voltage level allows an electrical arc to be extinguished.

6. The method of any of claims 1-5, wherein the power device (802, 850) is a system power device (850) that draws the input power from a plurality of photovoltaic generators (800).

7. A power device (802, 850) comprising:
   one or more controllers (804) configured to cause the power device to:

   draw input power from at least one photovoltaic generator (800), wherein the input power is at a first voltage level and a first current level;
   provide output power at an output of the power device (802, 850);
   reduce an electrical parameter of the input power to a level that allows an electrical arc to be extinguished, the electrical parameter being at least one of a voltage of the input power and a current of the input power;
   **characterized by** the controllers being further configured to:

      responsive to a first predetermined time period elapsing, increase the electrical parameter of the input power; and
      responsive to a second predetermined time period elapsing, again reduce the electrical parameter of the input power to the level that allows an electrical arc to be extinguished.

8. The power device of claim 7, wherein the power device (802, 850) is a photovoltaic inverter.

9. The power device of claim 7, wherein the power device (802, 850) is a direct current to direct current power converter.

10. The power device of any of claims 7-9, wherein the electrical parameter is the current of the input power, and wherein, to reduce the electrical parameter, the one or more controllers (804) are configured to cause the power device to reduce the current of the input power to a second current level, wherein the second current level allows an electrical arc to be extinguished.

11. The power device of any of claims 7-9, wherein the electrical parameter is the voltage of the input power, and wherein, to reduce the electrical parameter, the one or more controllers (804) are configured to cause the power device (802, 850) to reduce the voltage of the input power to a second voltage level, wherein the second voltage

level allows an electrical arc to be extinguished.

**12.** The power device of any of claims 7-11, wherein the power device (802, 850) is a system power device (850) that draws the input power from a plurality of photovoltaic generators (800).

## Patentansprüche

**1.** Verfahren, umfassend:

Beziehen einer Eingangsleistung aus mindestens einem Photovoltaik-Generator (800) durch eine Leistungsvorrichtung (802, 850), wobei die Eingangsleistung einen ersten Spannungspegel und einen ersten Stromstärkepegel hat;
Liefern einer Ausgangsleistung an einem Ausgang der Leistungsvorrichtung (802, 850);
Verringern eines elektrischen Parameters der Eingangsleistung auf einen Pegel, der es ermöglicht, dass ein Lichtbogen erlischt, wobei der elektrische Parameter mindestens einer aus einer Spannung der Eingangsleistung und einer Stromstärke der Eingangsleistung ist;
**gekennzeichnet durch** die folgenden Schritte:

in Reaktion auf das Ablaufen eines ersten vorbestimmten Zeitraums, Erhöhen des elektrischen Parameters der Eingangsleistung; und
in Reaktion auf das Ablaufen eines zweiten vorbestimmten Zeitraums, erneutes Verringern des elektrischen Parameters der Eingangsleistung auf einen Pegel, der es ermöglicht, dass ein Lichtbogen erlischt.

**2.** Verfahren gemäß Anspruch 1, wobei die Leistungsvorrichtung (802, 850) ein Photovoltaik-Inverter ist.

**3.** Verfahren gemäß Anspruch 1, wobei die Leistungsvorrichtung (802, 850) ein Gleichstromwandler ist.

**4.** Verfahren gemäß einem der Ansprüche 1 bis 3, wobei der elektrische Parameter die Stromstärke der Eingangsleistung ist und wobei ein Verringern des elektrischen Parameters ein Verringern der Stromstärke der Eingangsleistung auf einen zweiten Stromstärkepegel umfasst, wobei der zweite Stromstärkepegel es ermöglicht, dass ein Lichtbogen erlischt.

**5.** Verfahren gemäß einem der Ansprüche 1 bis 3, wobei der elektrische Parameter die Spannung der Eingangsleistung ist und wobei ein Verringern des elektrischen Parameters ein Verringern der Spannung der Eingangsleistung auf einen zweiten Spannungspegel umfasst, wobei der zweite Spannungspegel es ermöglicht, dass ein Lichtbogen erlischt.

**6.** Verfahren gemäß einem der Ansprüche 1 bis 5, wobei die Leistungsvorrichtung (802, 850) eine Systemleistungsvorrichtung (850) ist, die die Eingangsleistung aus einer Mehrzahl von Photovoltaik-Generatoren (800) bezieht.

**7.** Leistungsvorrichtung (802, 850), umfassend:
einen oder mehrere Controller (804), die dazu konfiguriert sind zu verursachen, dass die Leistungsvorrichtung:

eine Eingangsleistung aus mindestens einem Photovoltaik-Generator (800) bezieht, wobei die Eingangsleistung einen ersten Spannungspegel und einen ersten Stromstärkepegel hat;
eine Ausgangsleistung an einem Ausgang der Leistungsvorrichtung (802, 850) liefert;
einen elektrischen Parameter der Eingangsleistung auf einen Pegel verringert, der es ermöglicht, dass ein Lichtbogen erlischt, wobei der elektrische Parameter mindestens einer aus einer Spannung der Eingangsleistung und einer Stromstärke der Eingangsleistung ist;
**dadurch gekennzeichnet, dass** die Controller ferner dazu konfiguriert sind:

in Reaktion auf das Ablaufen eines ersten vorbestimmten Zeitraums, den elektrischen Parameter der Eingangsleistung zu erhöhen; und
in Reaktion auf das Ablaufen eines zweiten vorbestimmten Zeitraums, den elektrischen Parameter der Eingangsleistung erneut auf einen Pegel zu verringern, der es ermöglicht, dass ein Lichtbogen erlischt.

**8.** Leistungsvorrichtung gemäß Anspruch 7, wobei die Leistungsvorrichtung (802, 850) ein Photovoltaik-Inverter ist.

9. Leistungsvorrichtung gemäß Anspruch 7, wobei die Leistungsvorrichtung (802, 850) ein Gleichstromwandler ist.

10. Leistungsvorrichtung gemäß einem der Ansprüche 7 bis 9, wobei der elektrische Parameter die Stromstärke der Eingangsleistung ist und wobei zum Verringern des elektrischen Parameters der eine oder die mehreren Controller (804) dazu konfiguriert sind zu verursachen, dass die Leistungsvorrichtung die Stromstärke der Eingangsleistung auf einen zweiten Stromstärkepegel verringert, wobei der zweite Stromstärkepegel es ermöglicht, dass ein Lichtbogen erlischt.

11. Leistungsvorrichtung gemäß einem der Ansprüche 7 bis 9, wobei der elektrische Parameter die Spannung der Eingangsleistung ist und wobei zum Verringern des elektrischen Parameters der eine oder die mehreren Controller (804) dazu konfiguriert sind zu verursachen, dass die Leistungsvorrichtung (802, 850) die Spannung der Eingangsleistung auf einen zweiten Spannungspegel verringert, wobei der zweite Spannungspegel es ermöglicht, dass ein Lichtbogen erlischt.

12. Leistungsvorrichtung gemäß einem der Ansprüche 7 bis 11, wobei die Leistungsvorrichtung (802, 850) eine Systemleistungsvorrichtung (850) ist, die die Eingangsleistung aus einer Mehrzahl von Photovoltaik-Generatoren (800) bezieht.

## Revendications

1. Un procédé comprenant les étapes consistant à :

   absorber, par un dispositif d'alimentation (802, 850), la puissance d'entrée d'au moins un générateur photovoltaïque (800), dans lequel la puissance d'entrée est à un premier niveau de tension et à un premier niveau de courant ;
   fournir une puissance de sortie au niveau d'une sortie du dispositif d'alimentation (802, 850) ;
   réduire un paramètre électrique de la puissance d'entrée à un niveau permettant d'éteindre un arc électrique, le paramètre électrique étant au moins l'un parmi une tension de la puissance d'entrée et un courant de la puissance d'entrée ;
   **caractérisé par** les étapes consistant à :

      en réponse à l'écoulement d'une première période de temps prédéterminée, augmenter le paramètre électrique de la puissance d'entrée ; et
      en réponse à l'écoulement d'une deuxième période de temps prédéterminée, réduire à nouveau le paramètre électrique de la puissance d'entrée au niveau qui à un arc électrique de s'éteindre.

2. Procédé selon la revendication 1, dans lequel le dispositif d'alimentation (802, 850) est un onduleur photovoltaïque.

3. Procédé selon la revendication 1, dans lequel le dispositif d'alimentation (802, 850) est un convertisseur d'alimentation courant continu en courant continu.

4. Procédé selon l'une quelconque des revendications 1 à 3, dans lequel le paramètre électrique est le courant de la puissance d'entrée, et dans lequel la réduction du paramètre électrique comprend la réduction du courant de la puissance d'entrée à un deuxième niveau de courant, dans lequel le deuxième niveau de courant permet à un arc électrique de s'éteindre.

5. Procédé selon l'une quelconque des revendications 1 à 3, dans lequel le paramètre électrique est la tension de la puissance d'entrée, et dans lequel la réduction du paramètre électrique comprend la réduction de la tension de la puissance d'entrée à un deuxième niveau de tension, le deuxième niveau de tension permettant d'éteindre un arc électrique.

6. Procédé selon l'une quelconque des revendications 1 à 5, dans lequel le dispositif d'alimentation (802, 850) est un dispositif d'alimentation d'un système (850) qui absorbe la puissance d'entrée d'une pluralité de générateurs photovoltaïques (800).

7. Dispositif d'alimentation (802, 850) comprenant :
   un ou plusieurs contrôleurs (804) configurés pour amener le dispositif d'alimentation à :

absorber la puissance d'entrée d'au moins un générateur photovoltaïque (800), la puissance d'entrée étant à un premier niveau de tension et à un premier niveau de courant ;
fournir une puissance de sortie à une sortie du dispositif d'alimentation (802, 850);
réduire un paramètre électrique de la puissance d'entrée à un niveau qui permet à un arc électrique de s'éteindre, le paramètre électrique étant au moins l'un parmi une tension de la puissance d'entrée et un courant de la puissance d'entrée ; **caractérisé en ce que** les contrôleurs sont en outre configurés pour :
en réponse à l'écoulement d'une première période de temps prédéterminée, augmenter le paramètre électrique de la puissance d'entrée ; et
en réponse à l'écoulement d'une deuxième période de temps prédéterminée, réduire à nouveau le paramètre électrique de la puissance d'entrée au niveau qui permet à un arc électrique de s'éteindre.

**8.** Dispositif d'alimentation selon la revendication 7, dans lequel le dispositif d'alimentation (802, 850) est un onduleur photovoltaïque.

**9.** Dispositif d'alimentation selon la revendication 7, dans lequel le dispositif d'alimentation (802, 850) est un convertisseur de courant continu en courant continu.

**10.** Dispositif d'alimentation selon l'une quelconque des revendications 7 à 9, dans lequel le paramètre électrique est le courant de la puissance d'entrée, et dans lequel, pour réduire le paramètre électrique, le ou les contrôleurs (804) sont configurés pour amener le dispositif d'alimentation à réduire le courant de la puissance d'entrée à un deuxième niveau de courant, dans lequel le deuxième niveau de courant permet à un arc électrique de s'éteindre.

**11.** Dispositif d'alimentation selon l'une quelconque des revendications 7 à 9, dans lequel le paramètre électrique est la tension de la puissance d'entrée, et dans lequel, pour réduire le paramètre électrique, le ou les contrôleurs (804) sont configurés pour amener le dispositif d'alimentation (802, 850) à réduire la tension de la puissance d'entrée à un deuxième niveau de tension, le deuxième niveau de tension permettant d'éteindre un arc électrique.

**12.** Dispositif d'alimentation selon l'une quelconque des revendications 7 à 11, dans lequel le dispositif d'alimentation (802, 850) est un dispositif d'alimentation d'un système (850) qui absorbe la puissance d'entrée d'une pluralité de générateurs photovoltaïques (800).

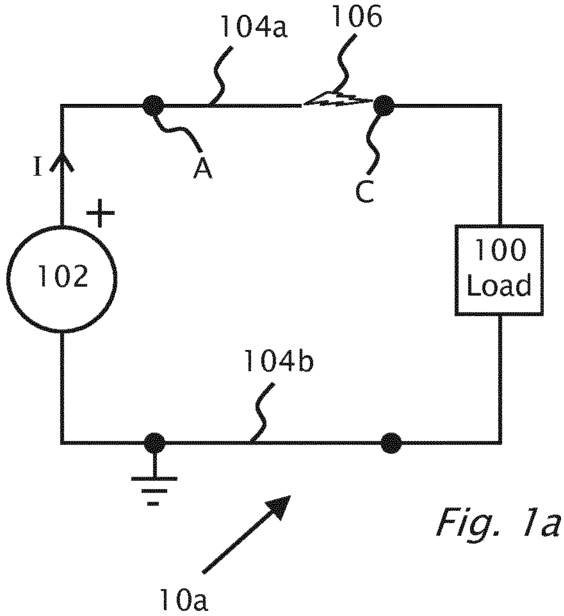
104a
106
I
A
C
102
100
Load
104b
10a

Fig. 1a

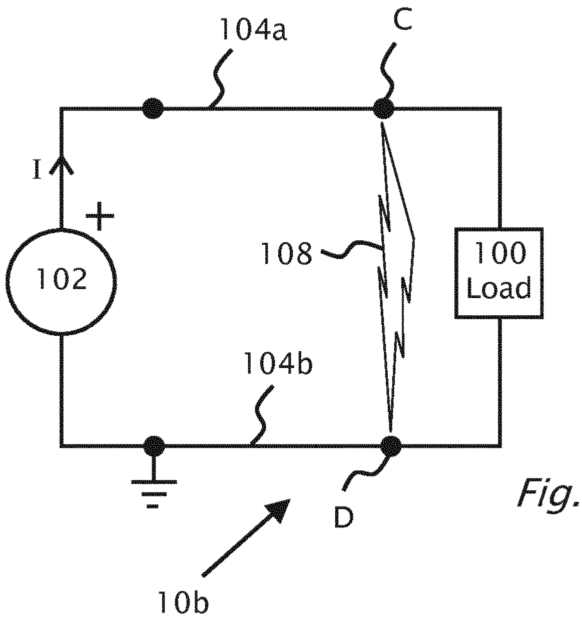
104a
C
I
102
108
100
Load
104b
D
10b

Fig. 1b

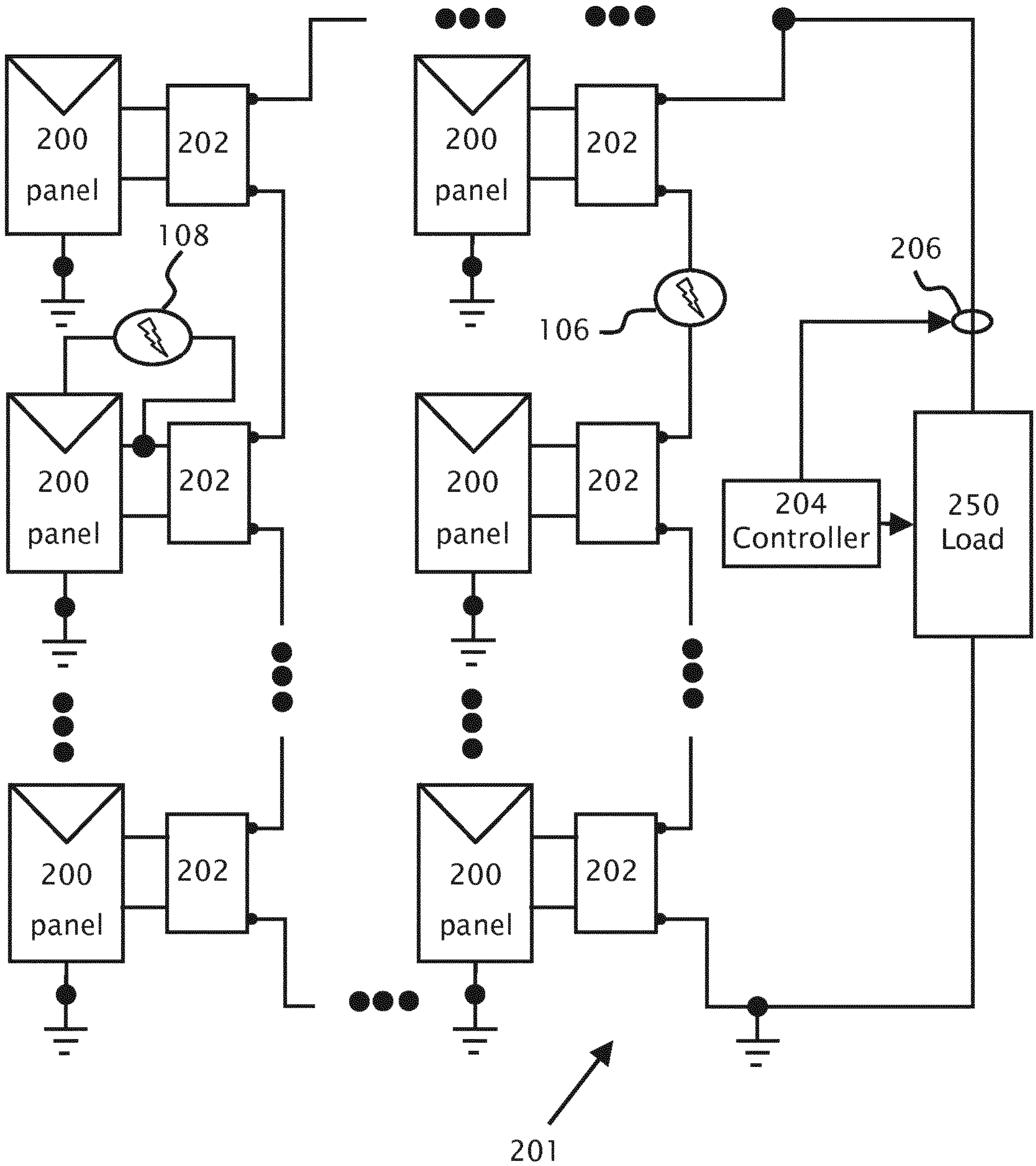
200
panel
202
108
200
panel
202
200
panel
202
200
panel
202
106
200
panel
202
200
panel
202
206
204
Controller
250
Load
201

*Fig. 2*

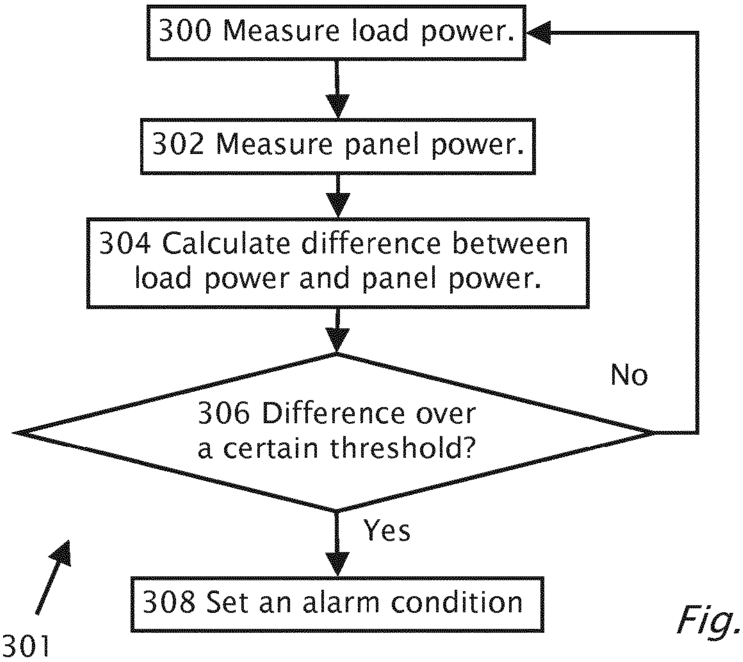


301

Fig. 3

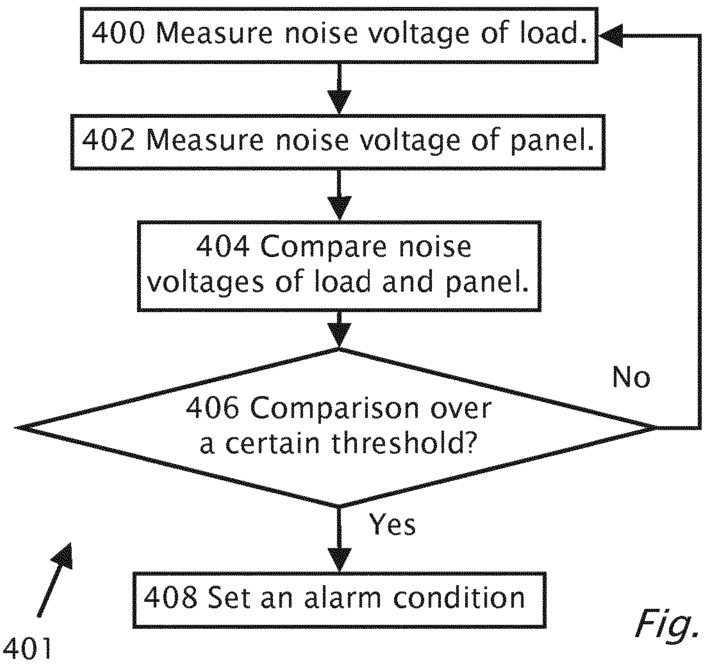


401

Fig. 4

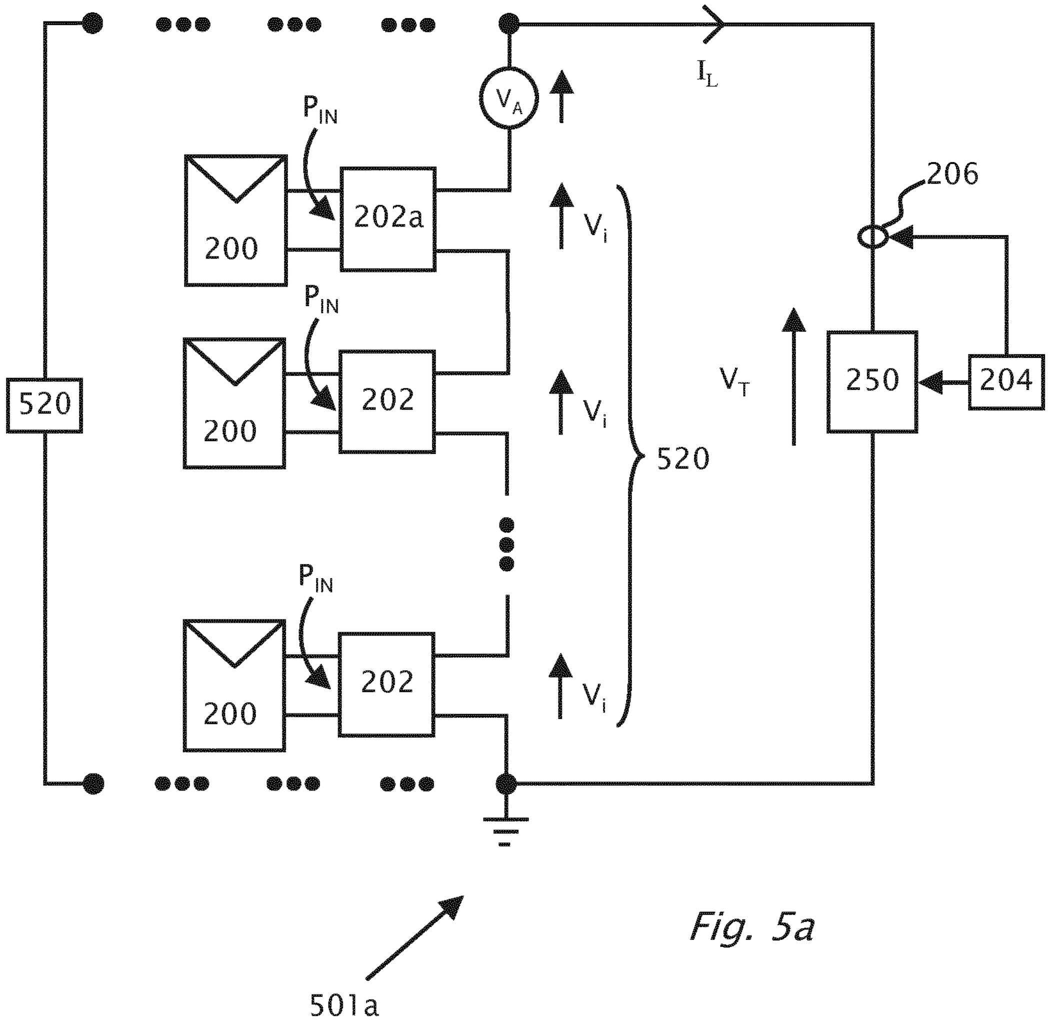

$P_{IN}$
$P_{IN}$
$P_{IN}$
200
200
200
202a
202
202
$V_A$
$I_L$
$V_i$
$V_i$
$V_i$
520
520
$V_T$
206
250
204
501a


*Fig. 5a*

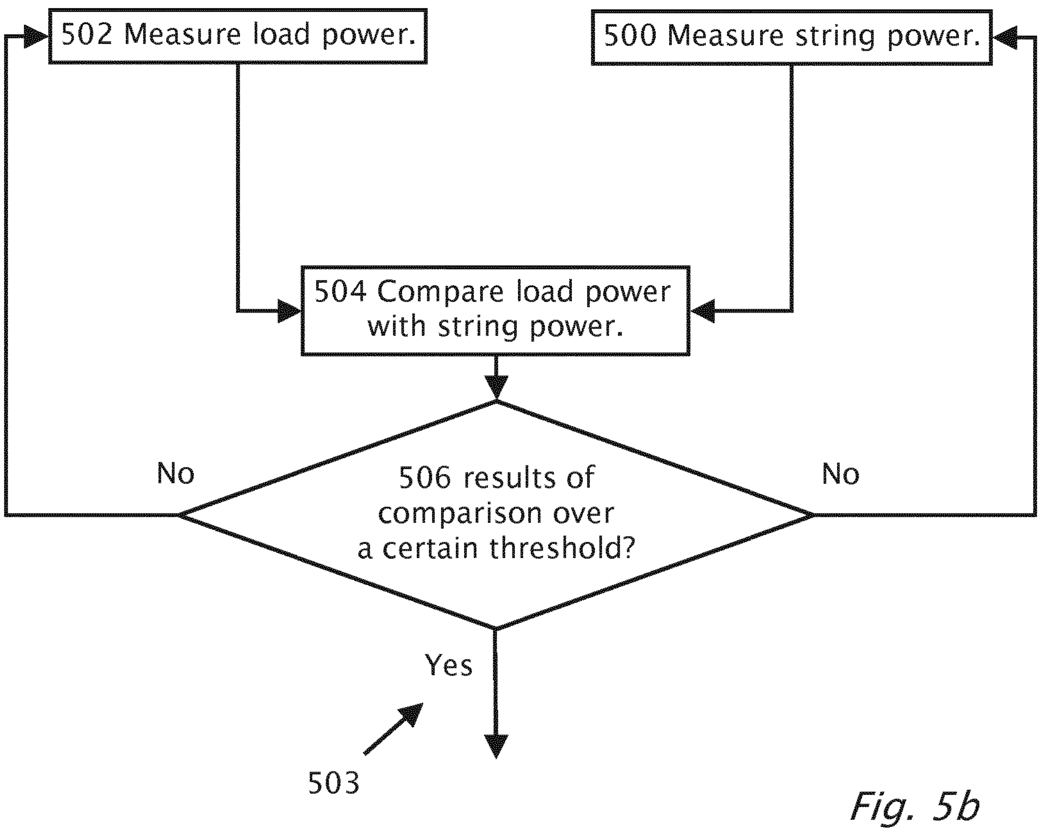
502 Measure load power.
500 Measure string power.
504 Compare load power with string power.
No
506 results of comparison over a certain threshold?
No
Yes
503

Fig. 5b

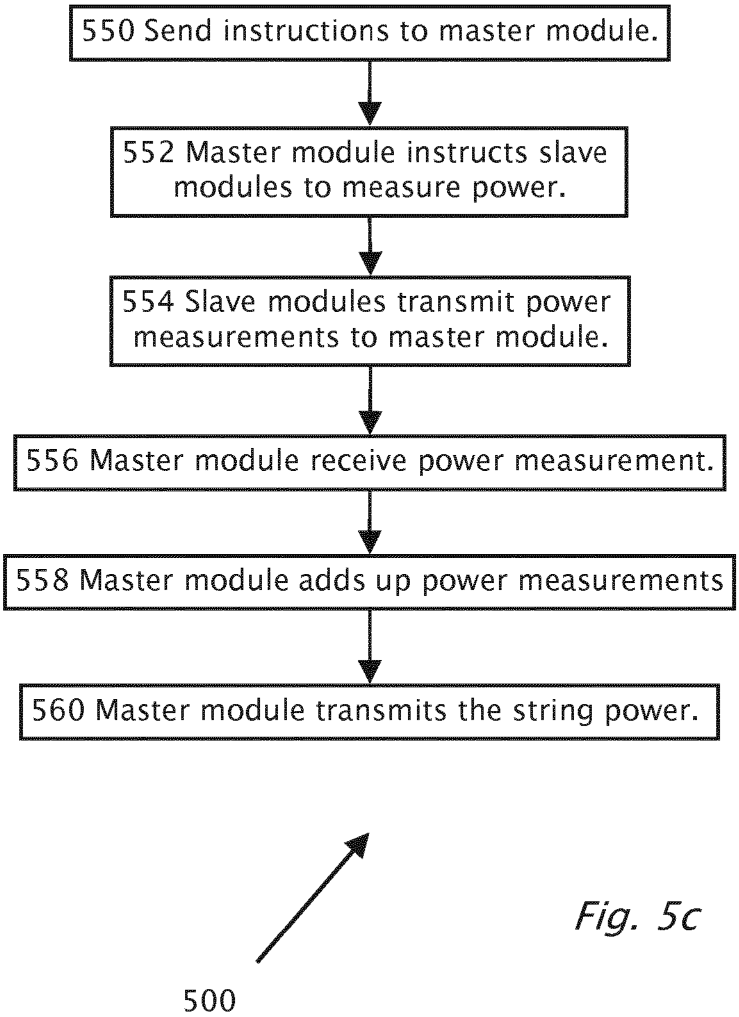
550 Send instructions to master module.
552 Master module instructs slave modules to measure power.
554 Slave modules transmit power measurements to master module.
556 Master module receive power measurement.
558 Master module adds up power measurements
560 Master module transmits the string power.
500

Fig. 5c

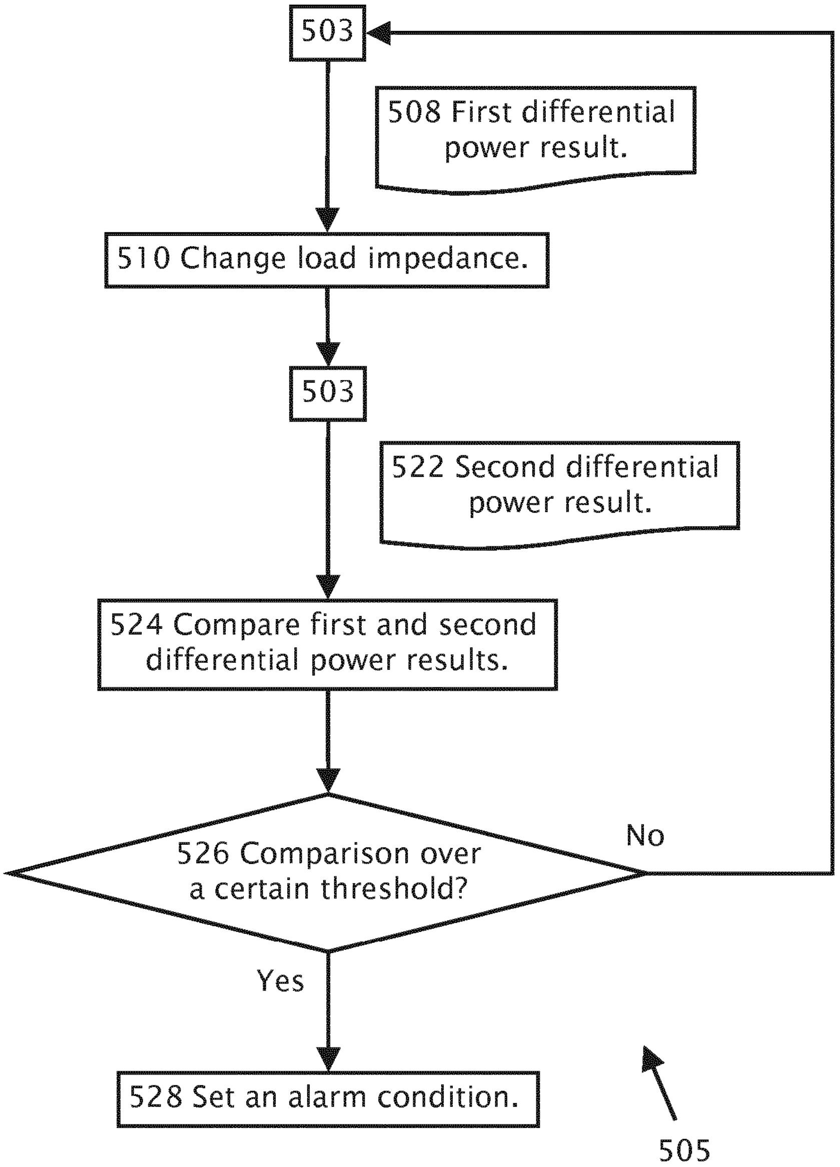
503
508 First differential power result.
510 Change load impedance.
503
522 Second differential power result.
524 Compare first and second differential power results.
526 Comparison over a certain threshold?
No
Yes
528 Set an alarm condition.
505

*Fig. 5d*

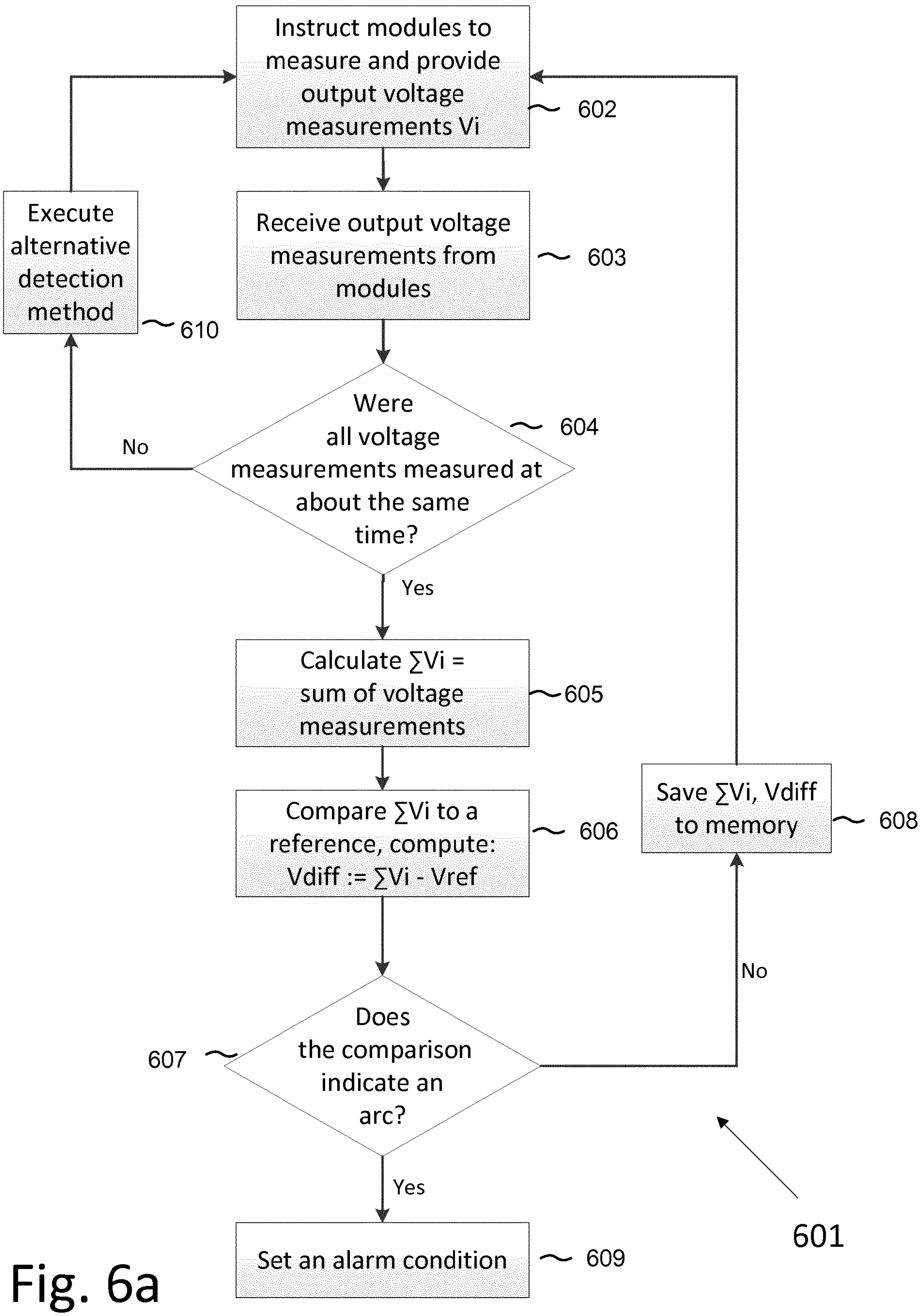
Instruct modules to measure and provide output voltage measurements Vi
602
Receive output voltage measurements from modules
603
Execute alternative detection method
610
Were all voltage measurements measured at about the same time?
604
No
Yes
Calculate ∑Vi = sum of voltage measurements
605
Compare ∑Vi to a reference, compute: Vdiff := ∑Vi - Vref
606
Save ∑Vi, Vdiff to memory
608
No
Does the comparison indicate an arc?
607
Yes
Set an alarm condition
609
601

Fig. 6a

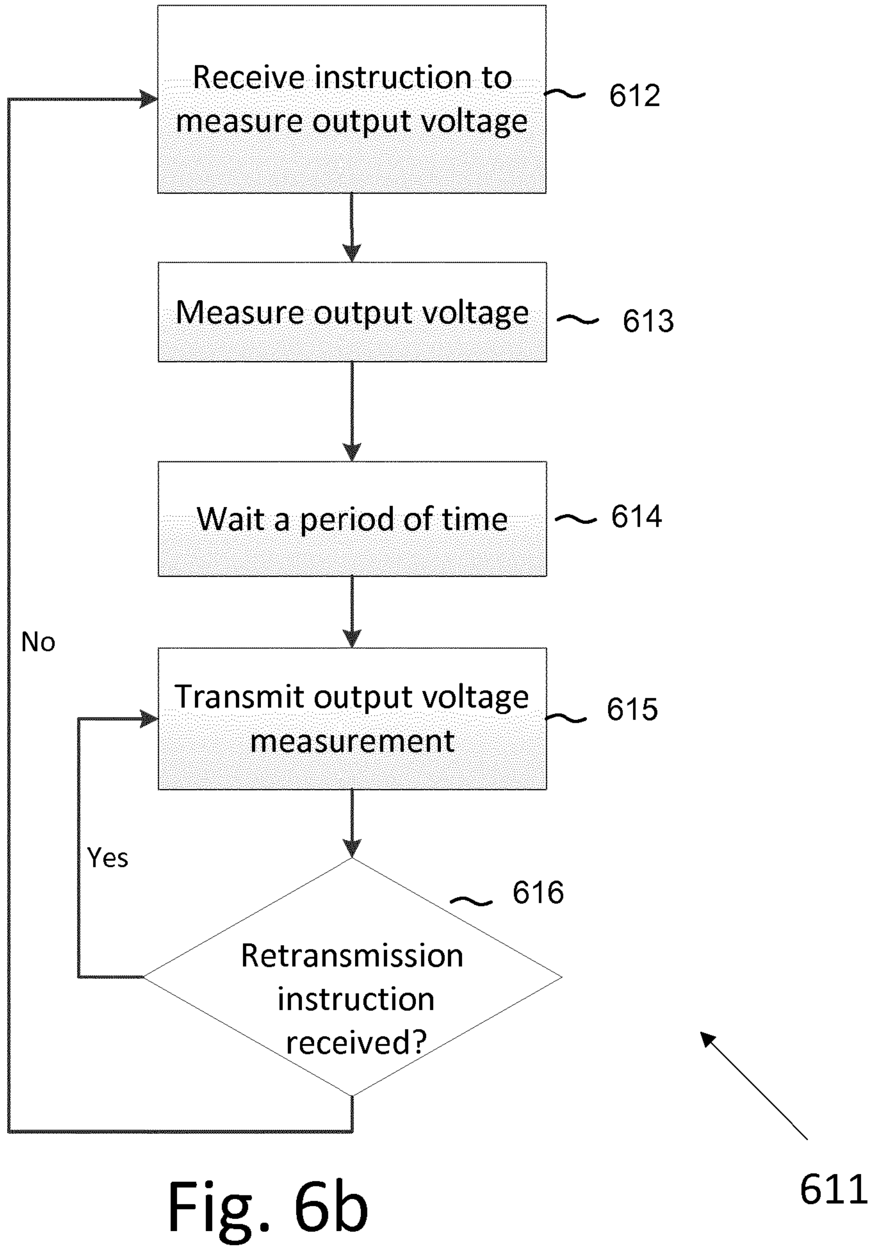

Receive instruction to measure output voltage
612
Measure output voltage
613
Wait a period of time
614
No
Transmit output voltage measurement
615
Yes
616
Retransmission instruction received?
611


Fig. 6b

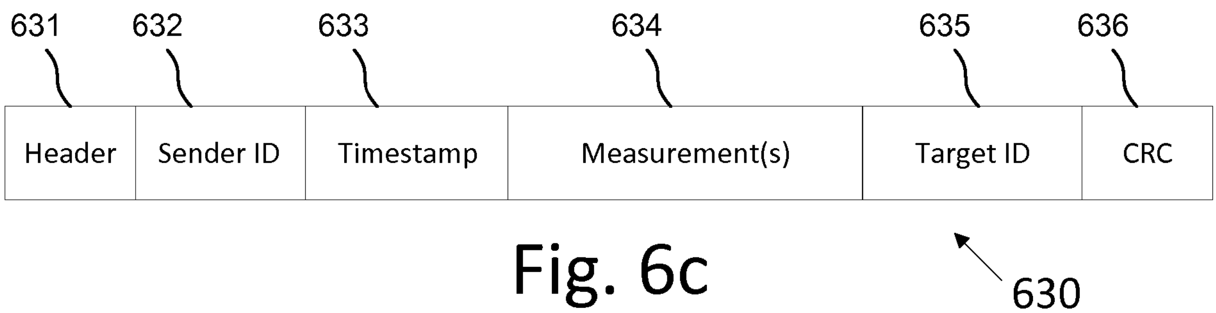

631
632
633
634
635
636
Header
Sender ID
Timestamp
Measurement(s)
Target ID
CRC
630


Fig. 6c

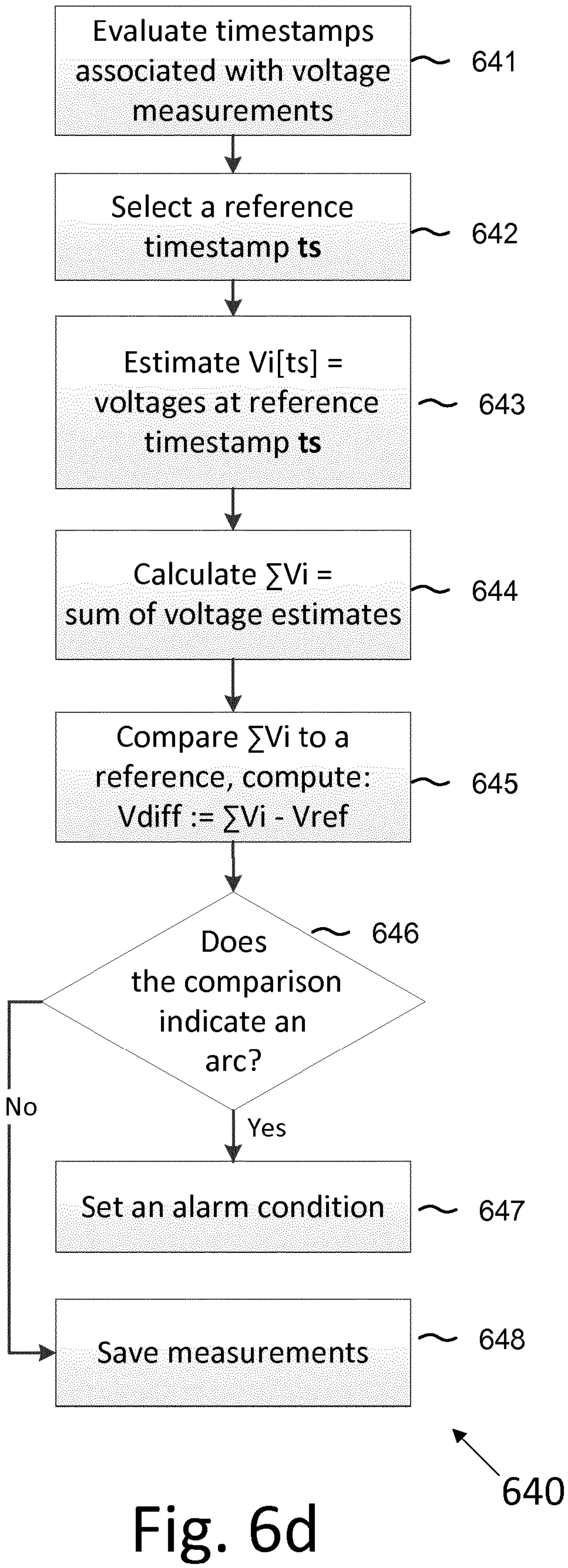
Evaluate timestamps associated with voltage measurements
641
Select a reference timestamp **ts**
642
Estimate Vi[ts] = voltages at reference timestamp **ts**
643
Calculate ∑Vi = sum of voltage estimates
644
Compare ∑Vi to a reference, compute: Vdiff := ∑Vi - Vref
645
Does the comparison indicate an arc?
646
No
Yes
Set an alarm condition
647
Save measurements
648
640

Fig. 6d

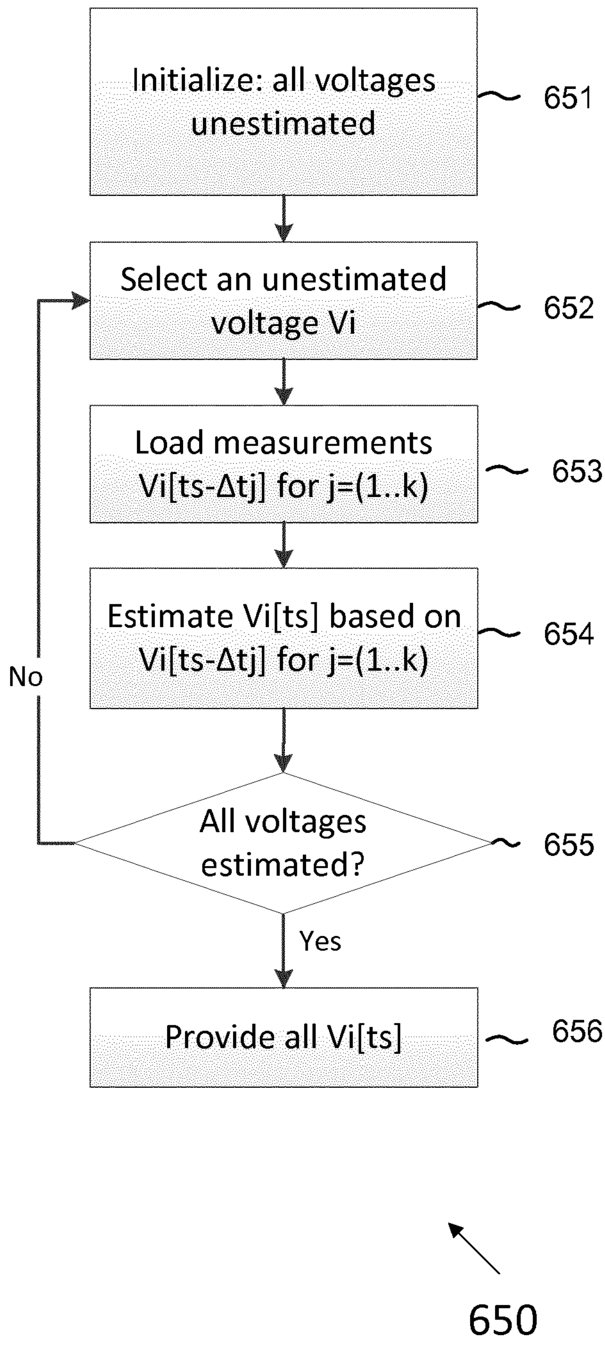
Initialize: all voltages unestimated
651
Select an unestimated voltage Vi
652
Load measurements Vi[ts-Δtj] for j=(1..k)
653
Estimate Vi[ts] based on Vi[ts-Δtj] for j=(1..k)
654
No
All voltages estimated?
655
Yes
Provide all Vi[ts]
656
650

Fig. 6e

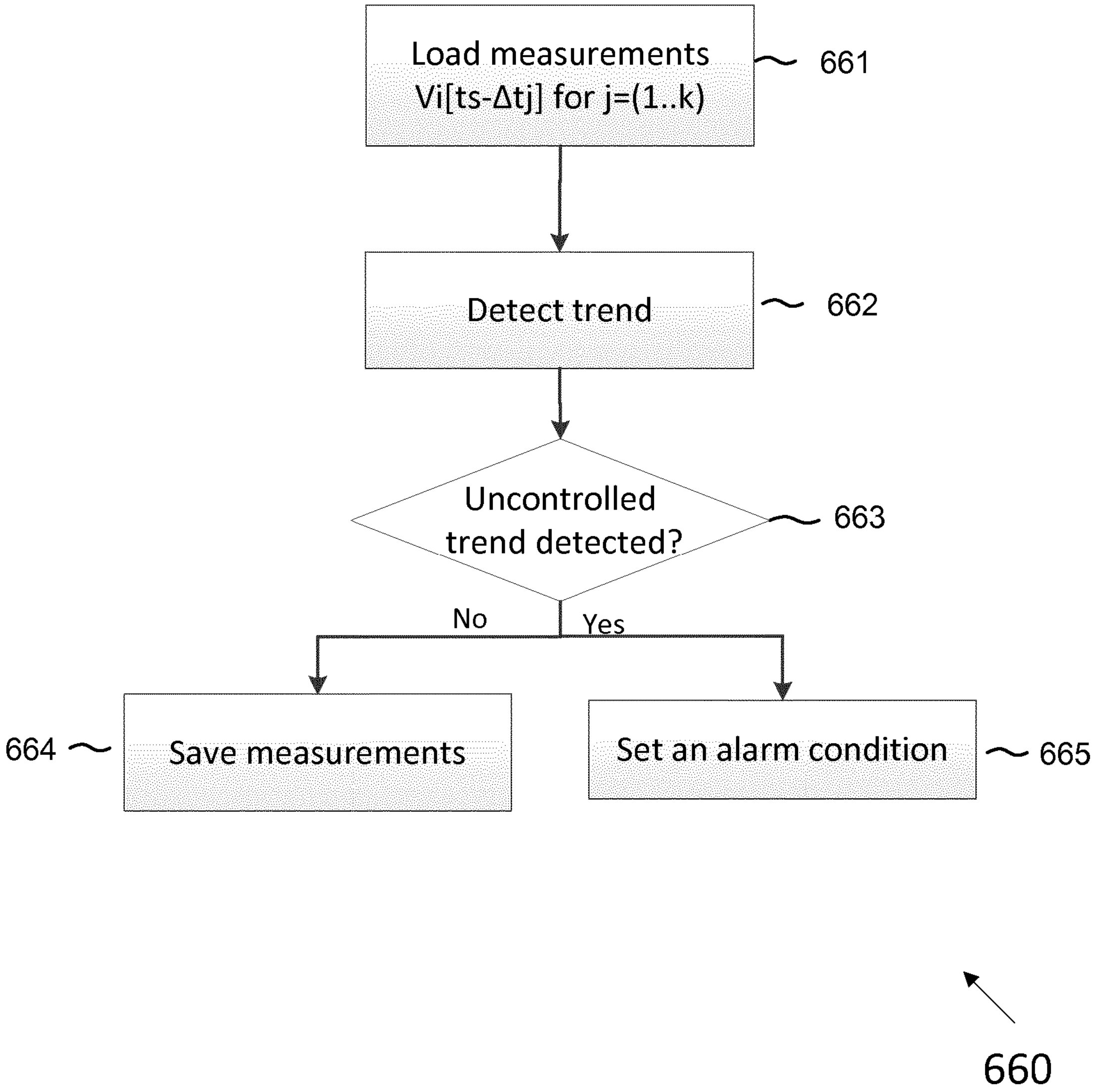
Load measurements
Vi[ts-Δtj] for j=(1..k)
661
Detect trend
662
Uncontrolled
trend detected?
663
No
Yes
664
Save measurements
Set an alarm condition
665
660

Fig. 6f

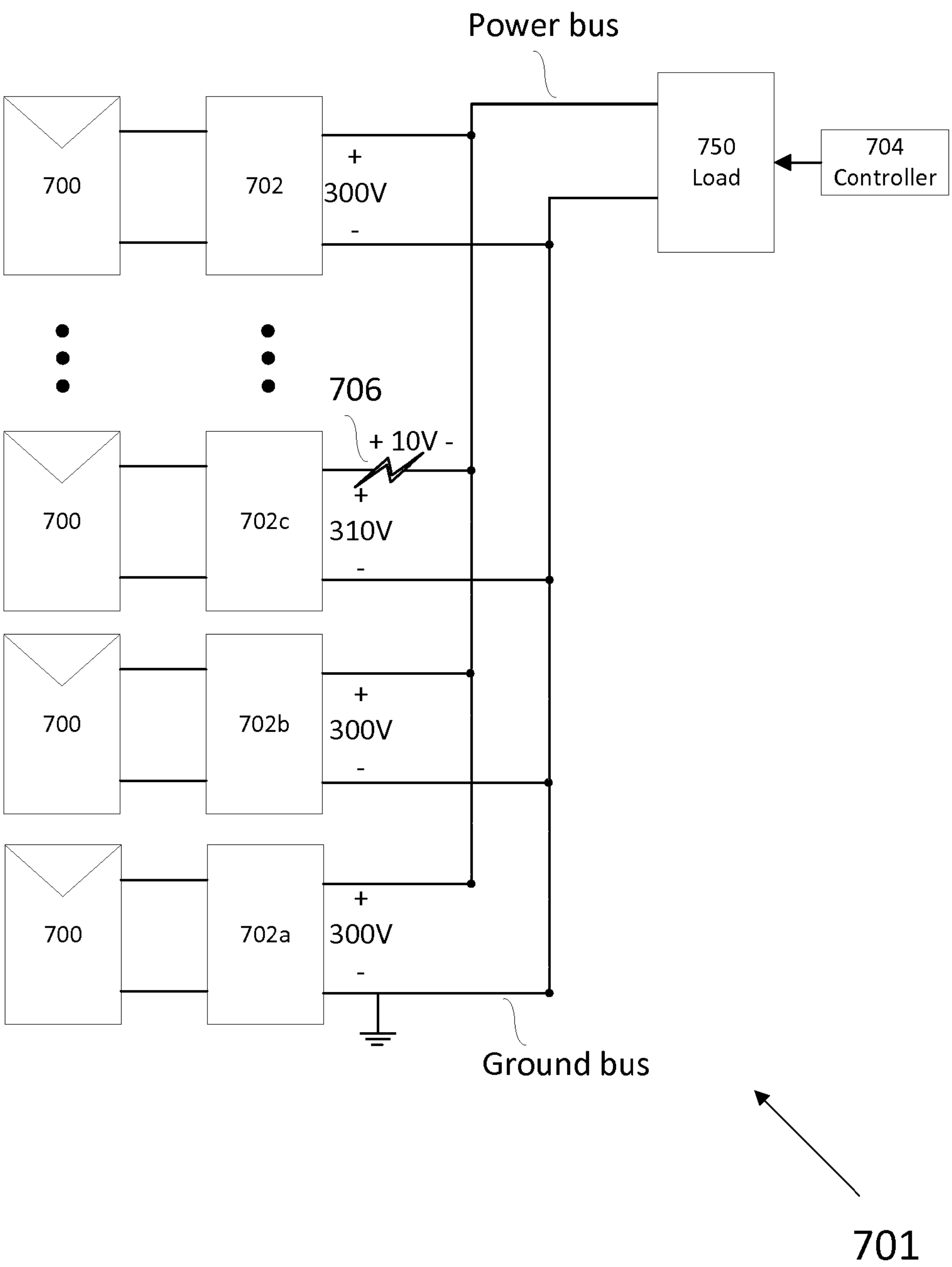
Power bus
750
Load
704
Controller
700
702
+
300V
-
706
+ 10V -
700
702c
+
310V
-
700
702b
+
300V
-
700
702a
+
300V
-
Ground bus
701

Fig. 7a

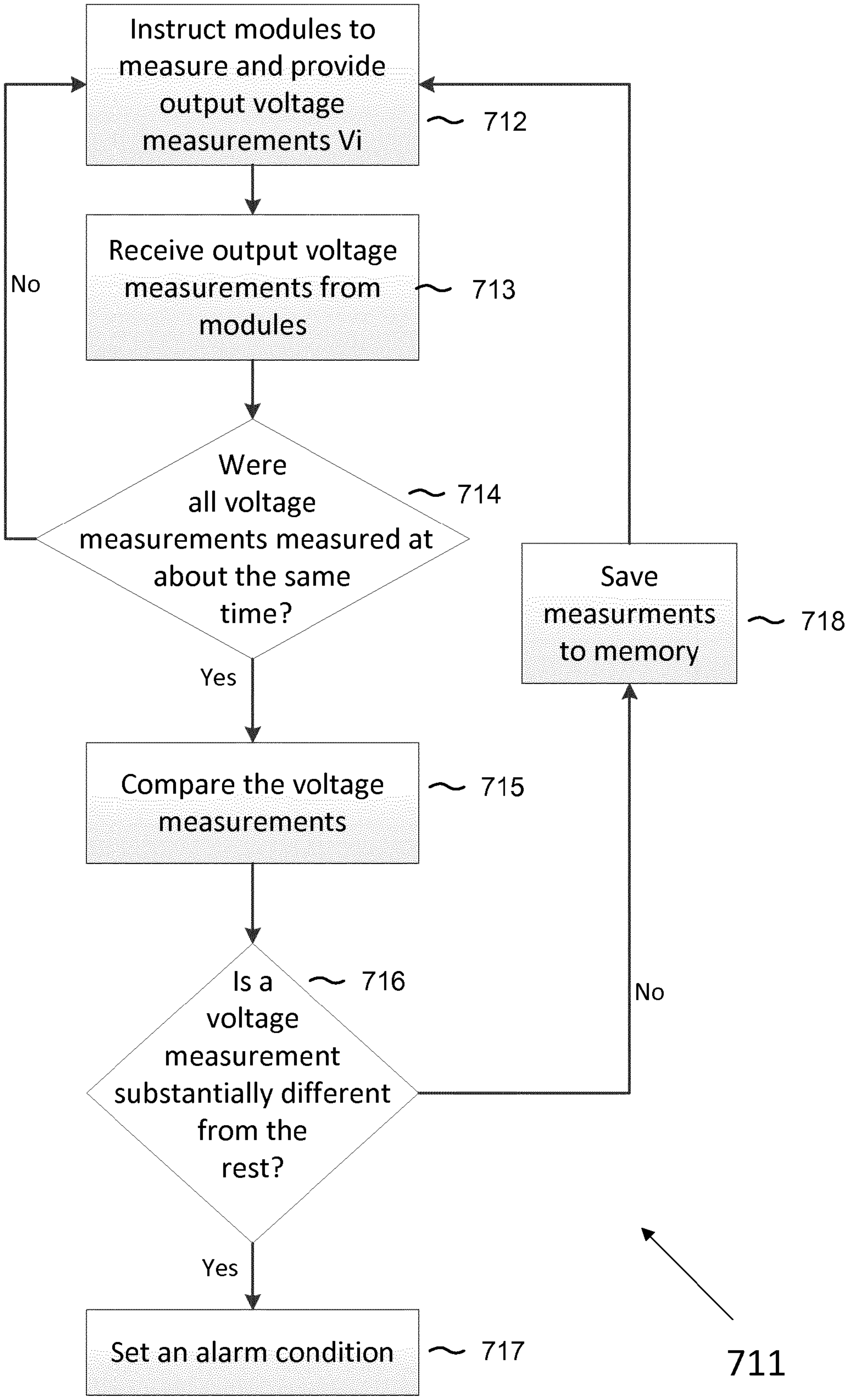
Instruct modules to measure and provide output voltage measurements Vi
712
Receive output voltage measurements from modules
713
No
Were all voltage measurements measured at about the same time?
714
Yes
Save measurments to memory
718
Compare the voltage measurements
715
Is a voltage measurement substantially different from the rest?
716
No
Yes
Set an alarm condition
717
711

Fig. 7b

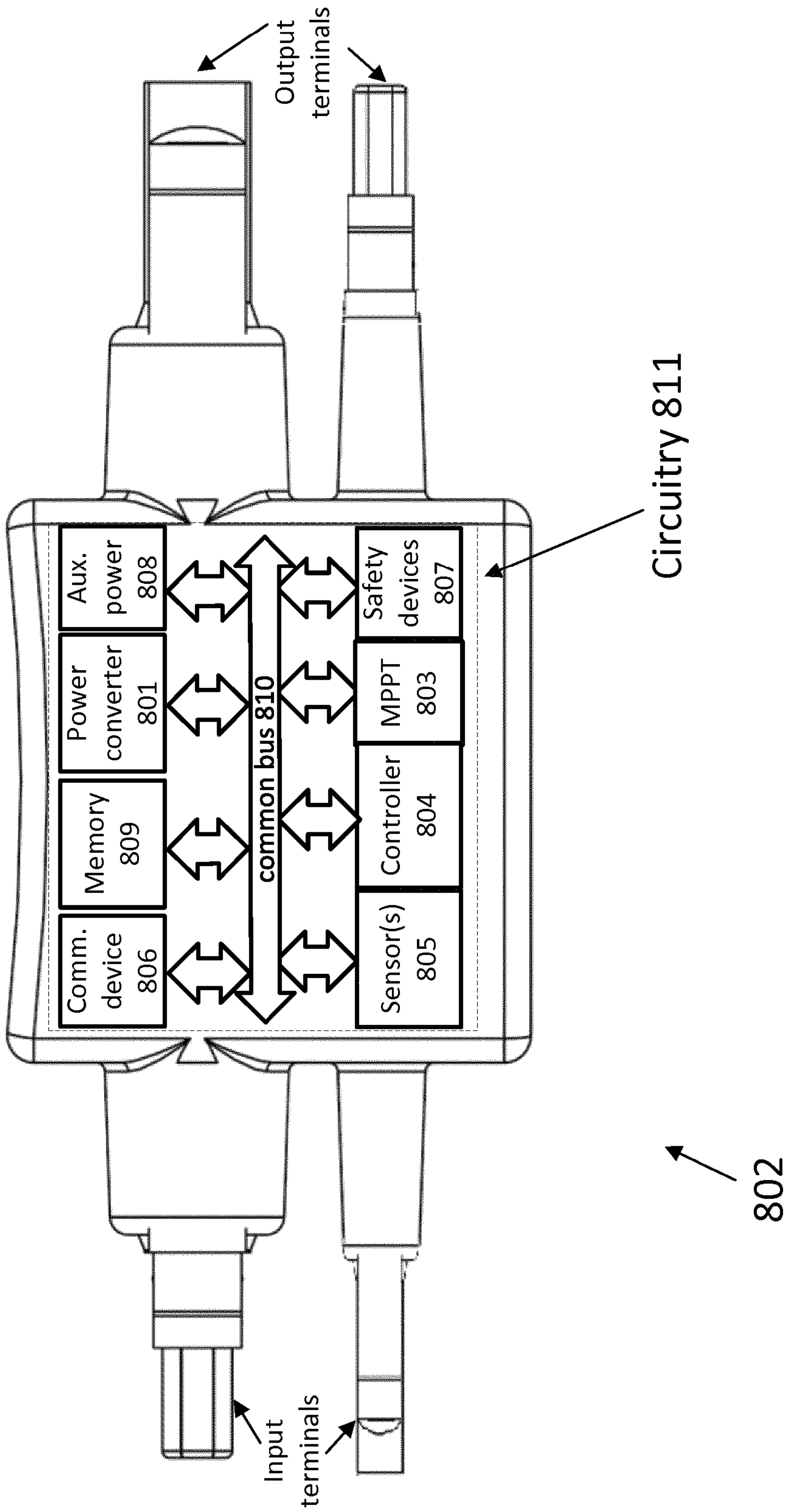
Output terminals
Aux. power 808
Power converter 801
Memory 809
Comm. device 806
common bus 810
Safety devices 807
MPPT 803
Controller 804
Sensor(s) 805
Circuitry 811
802
Input terminals

Fig. 8a

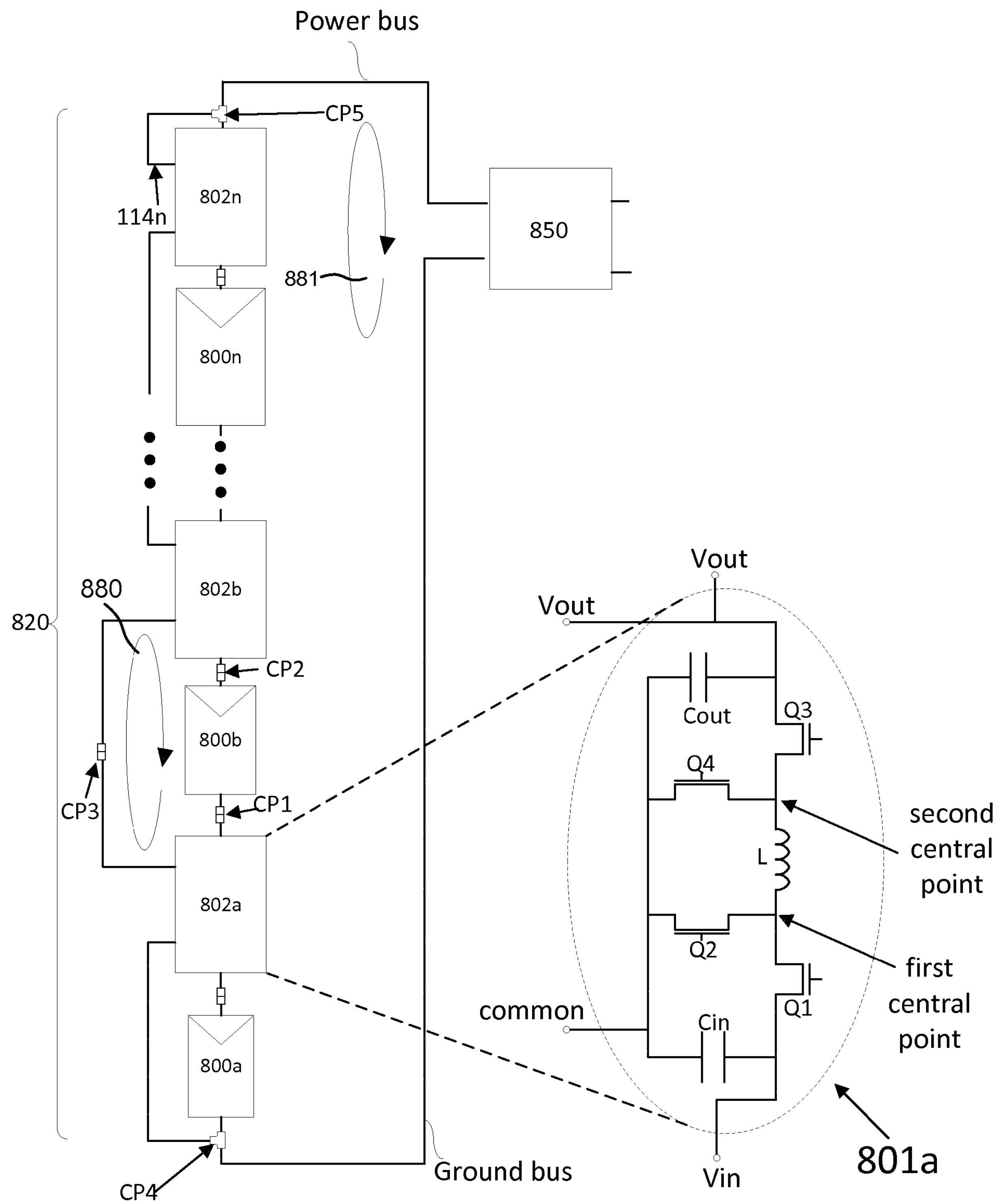

Power bus
CP5
802n
114n
881
850
800n
802b
880
820
CP2
800b
CP3
CP1
802a
800a
CP4
Ground bus
Vout
Vout
Cout
Q3
Q4
second central point
L
Q2
first central point
common
Cin
Q1
Vin
801a


Fig. 8b

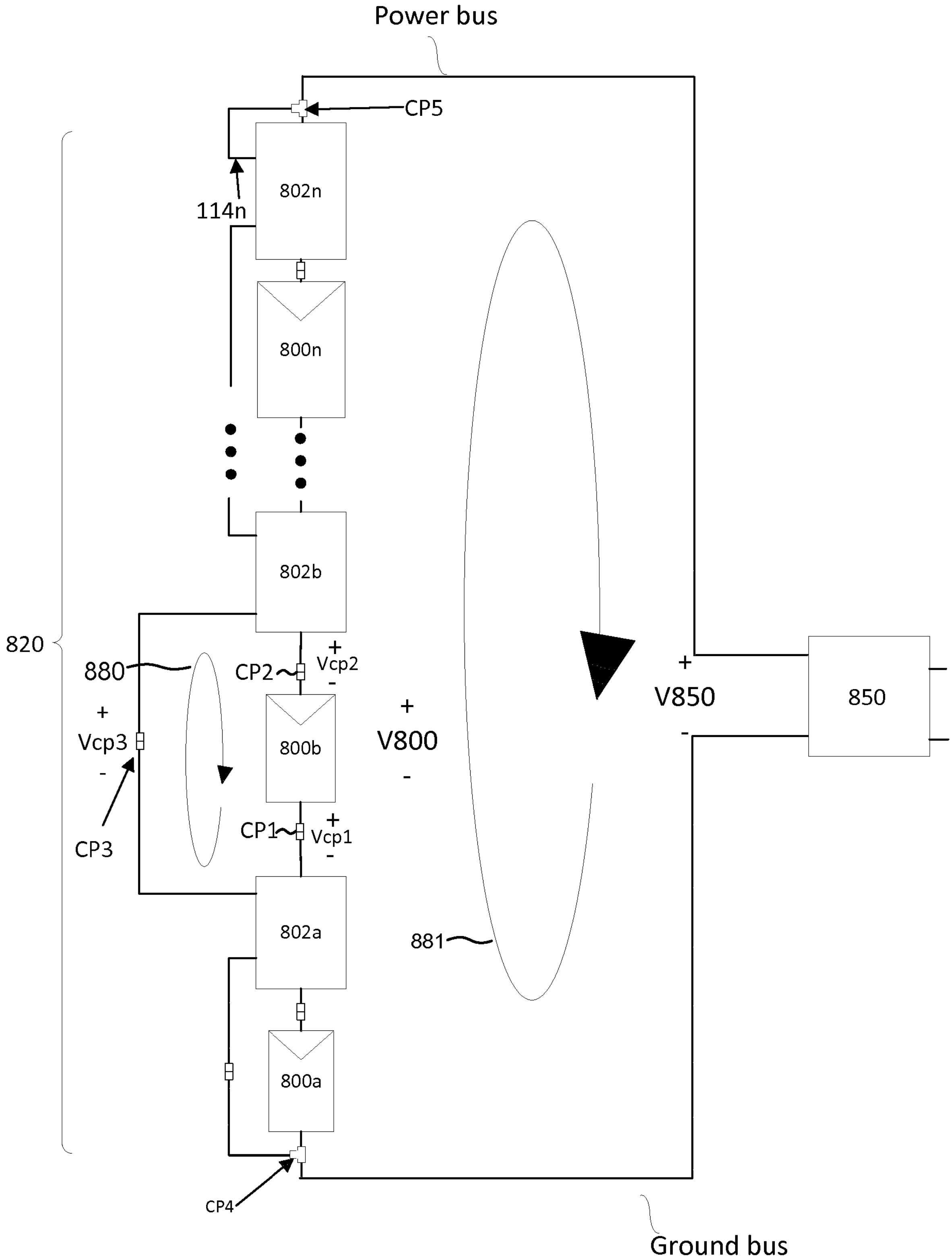
Power bus
CP5
802n
114n
800n
820
802b
880
CP2
+
Vcp2
-
+
Vcp3
-
800b
+
V800
-
+
V850
-
850
CP3
CP1
+
Vcp1
-
802a
881
800a
CP4
Ground bus

Fig. 8c

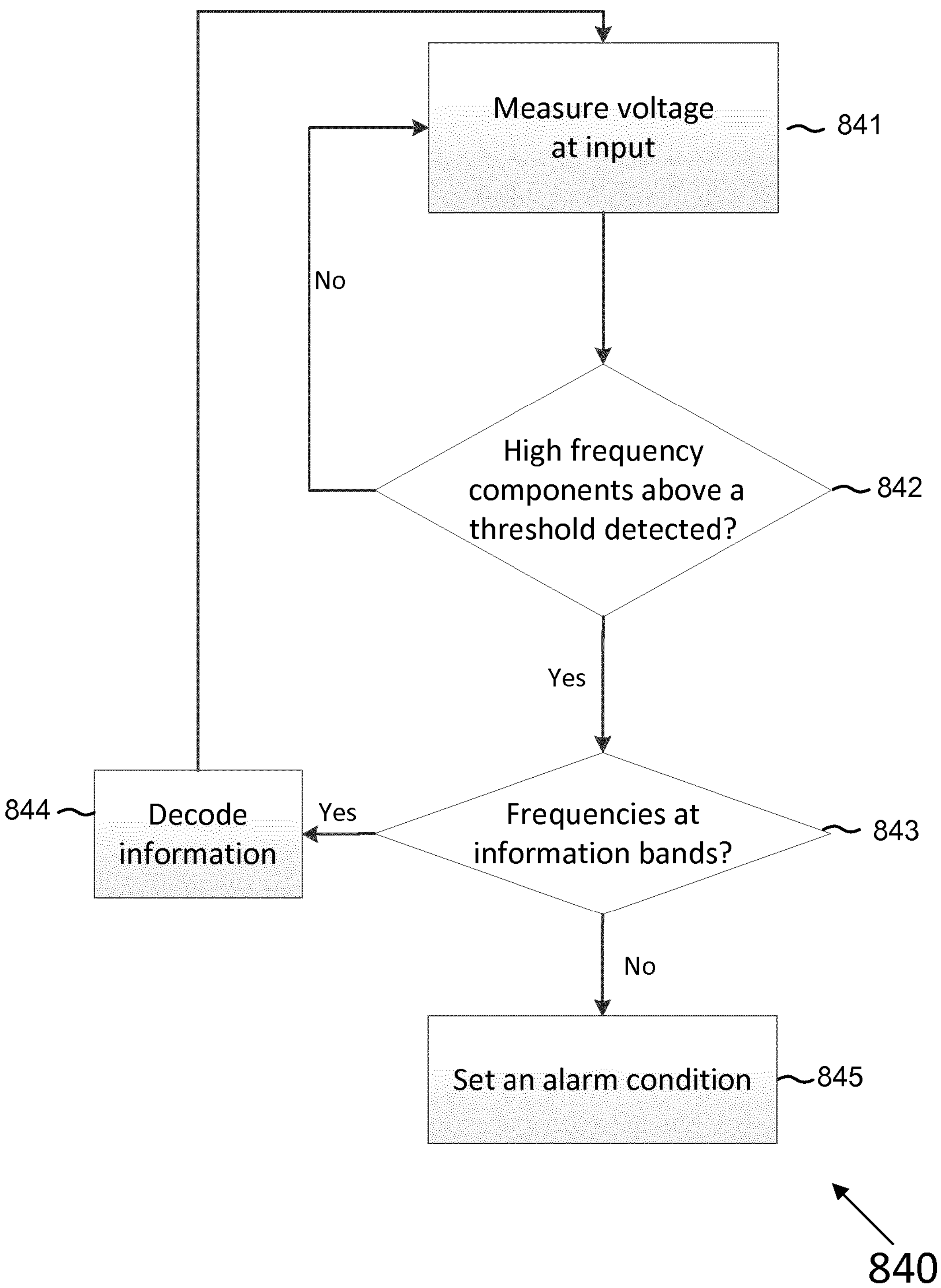
Measure voltage at input
841
No
High frequency components above a threshold detected?
842
Yes
844
Decode information
Yes
Frequencies at information bands?
843
No
Set an alarm condition
845
840

Fig. 8d

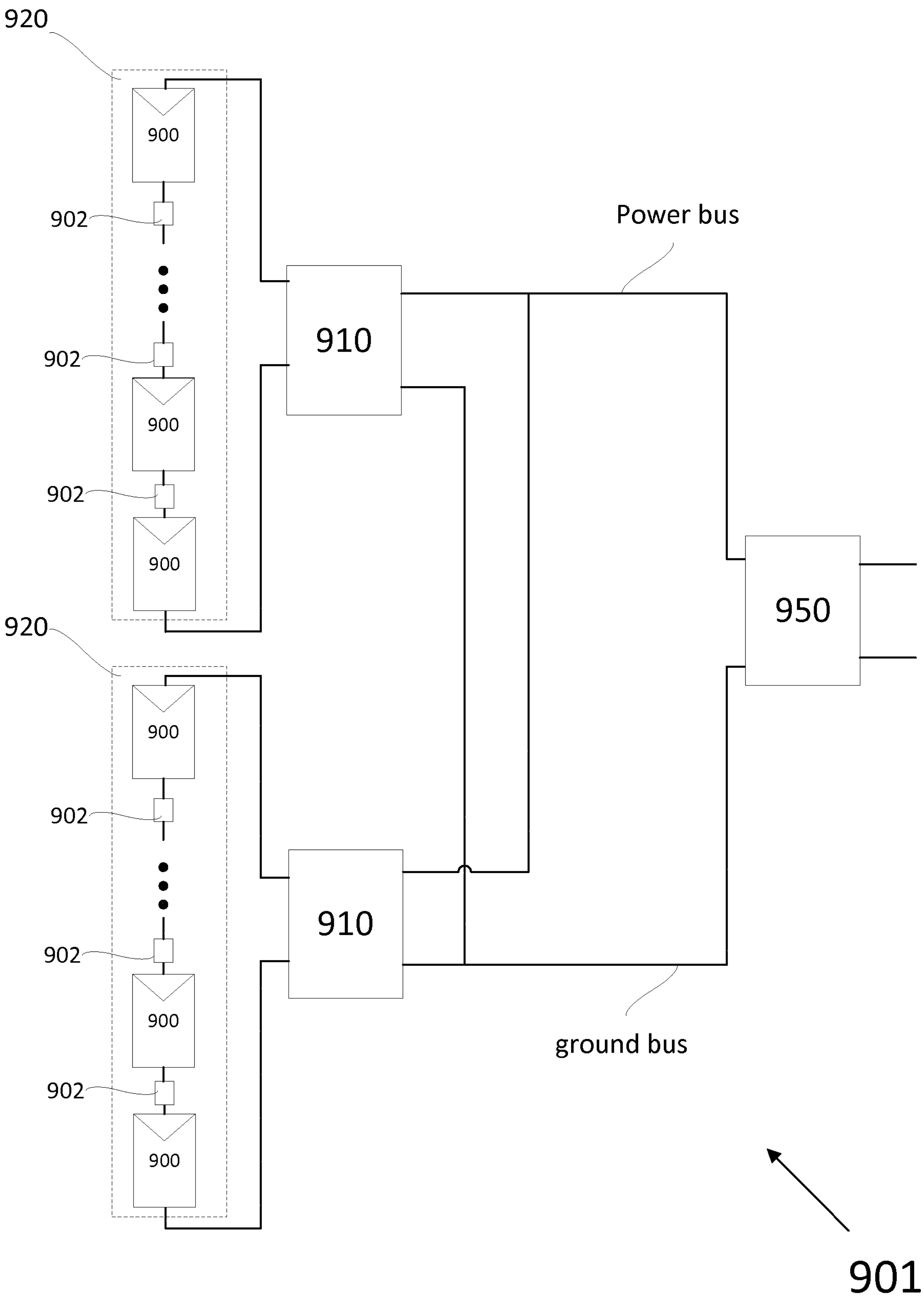
920
900
902
902
900
902
900
920
900
902
902
900
902
900
910
910
Power bus
ground bus
950
901

Fig. 9

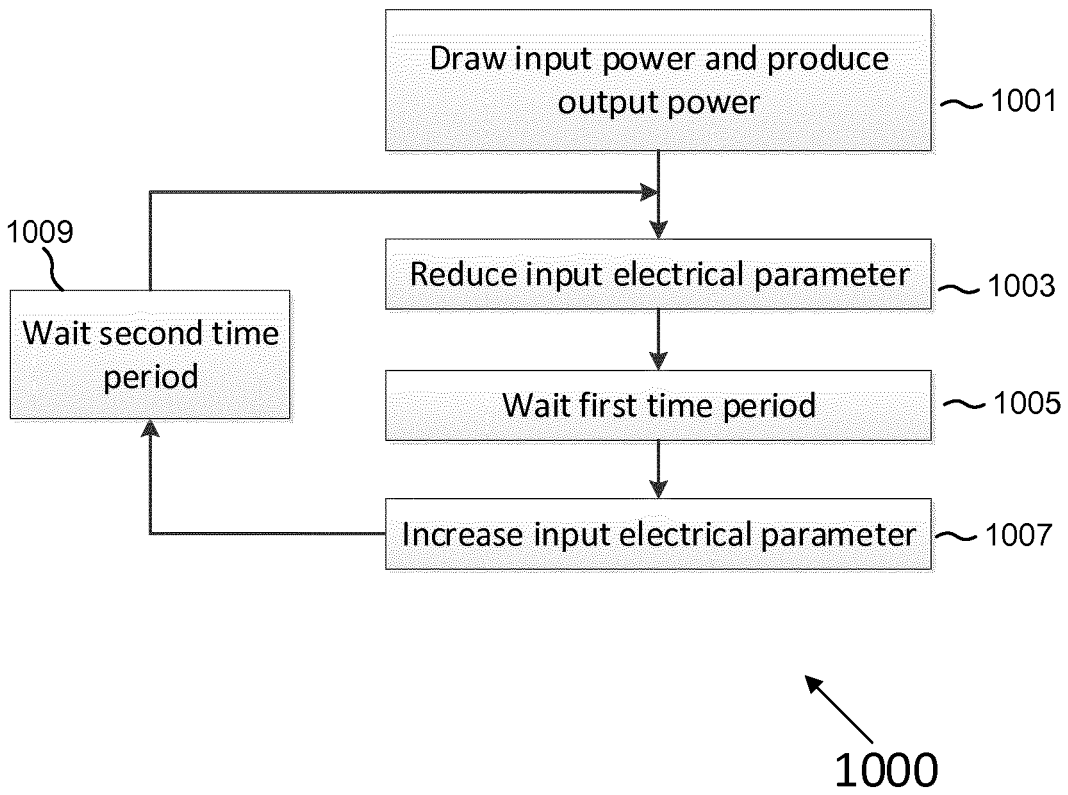
Draw input power and produce output power
1001
Reduce input electrical parameter
1003
Wait first time period
1005
Increase input electrical parameter
1007
Wait second time period
1009
1000

Fig. 10a

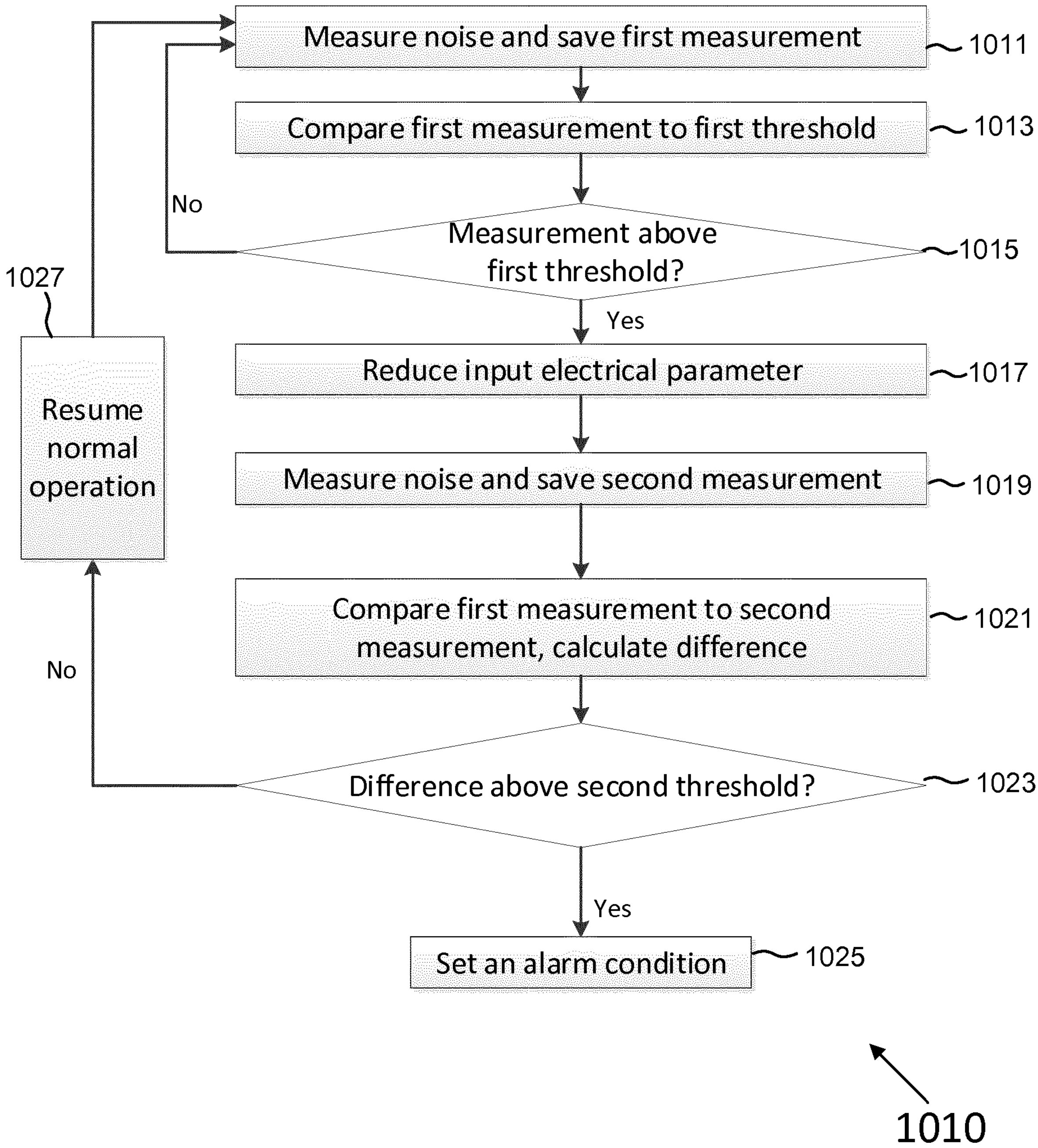
Measure noise and save first measurement
1011
Compare first measurement to first threshold
1013
No
Measurement above first threshold?
1015
Yes
Reduce input electrical parameter
1017
Measure noise and save second measurement
1019
Compare first measurement to second measurement, calculate difference
1021
Difference above second threshold?
1023
Yes
Set an alarm condition
1025
No
1027
Resume normal operation
1010

Fig. 10b

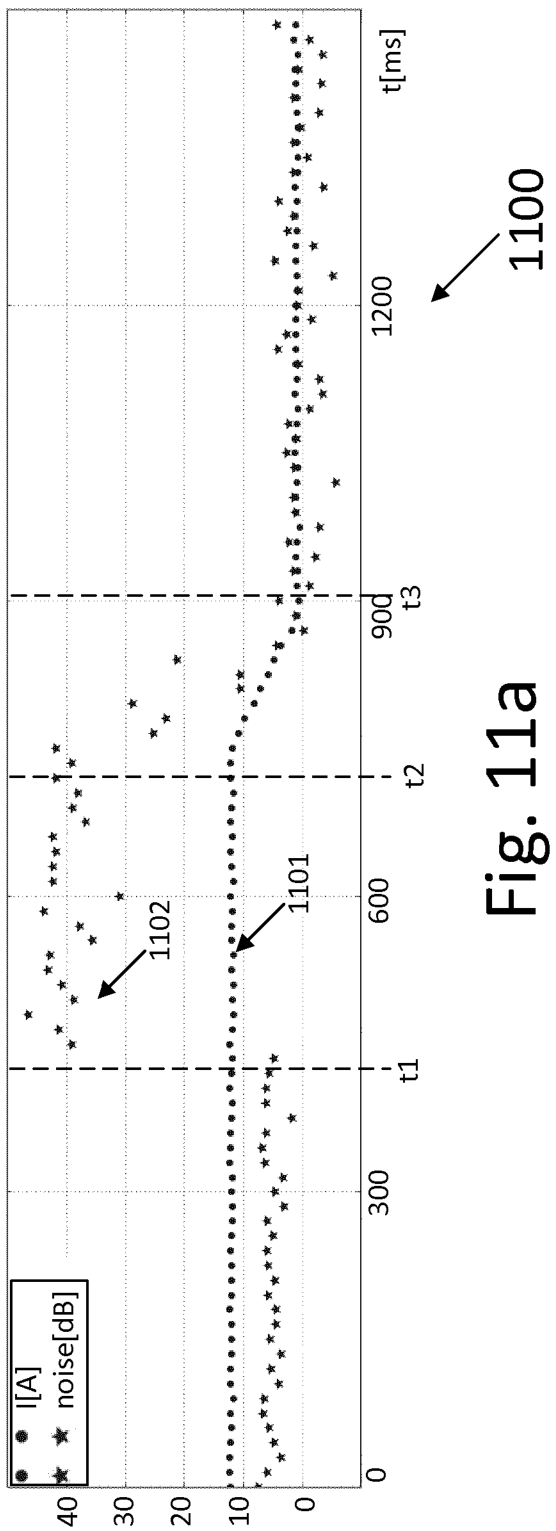


Fig. 11a

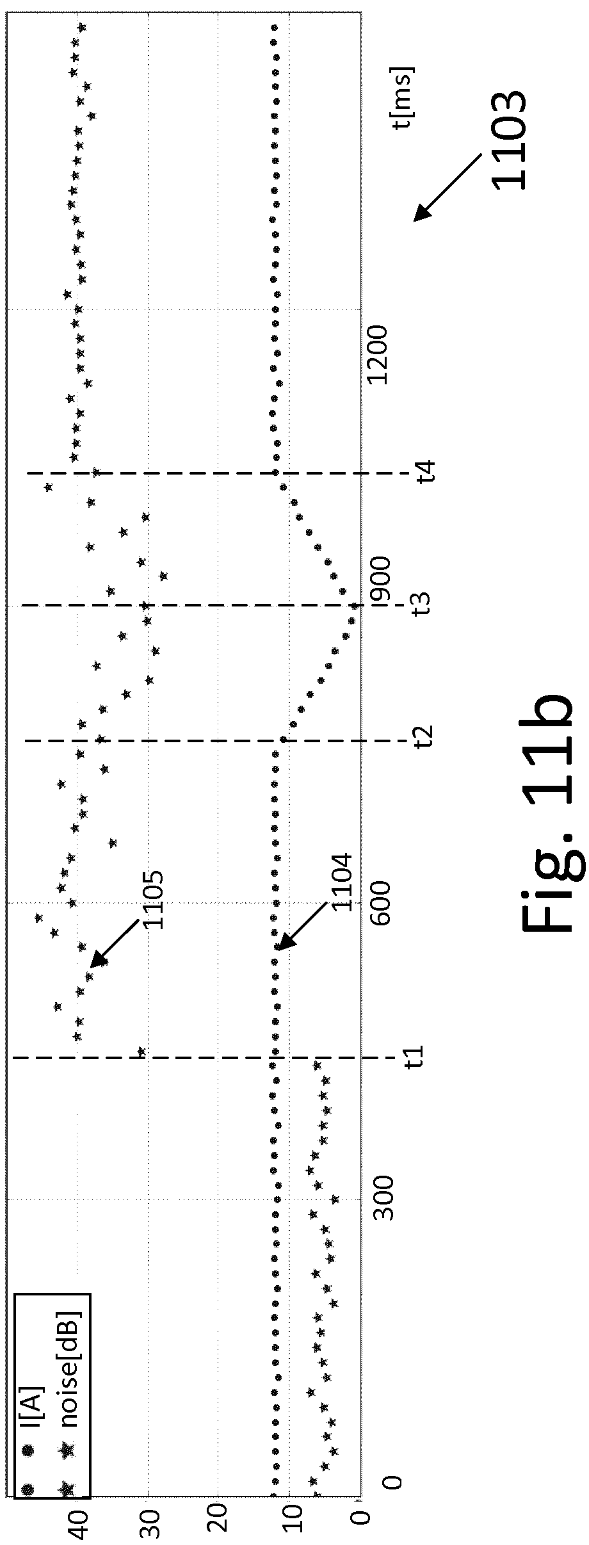


Fig. 11b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 40788117
- US 29052811
- GB 1018872 A
- US 407881
- US 25006816
- US 62318303
- US 62341147
- US 62395461
- US 20130335861 A1
- US 20150381111 A1